# EUROPEAN PATENT APPLICATION

(11) **EP 4 660 990 A1**
(43) Date of publication of application: **10.12.2025**
(21) Application number: 23937842.5
(22) Date of filing: 19.05.2023
(51) Int. Cl.: G09G 3/3208

(54) **DISPLAY SUBSTRATE AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: BAI, Lu, Beijing 100176 (CN); ZHOU, Yang, Beijing 100176 (CN); XU, Peng, Beijing 100176 (CN); WANG, Xinxin, Beijing 100176 (CN); QU, Yi, Beijing 100176 (CN); LIU, Song, Beijing 100176 (CN)
(74) Representative: Brötz, Helmut
(86) International application number: PCT/CN2023/095375
(87) International publication number: WO 2024/239163

(57) **Abstract**

Provided are a display substrate and a display apparatus. A shift register unit (104) is located in a non-display area (102B), and an input circuit (1041) inputs an input signal into a first node (N1) in response to a first clock signal; an output circuit (1043) outputs an output signal to an output end, and comprises an output transistor (T5); a first control circuit (1042) controls the level of a second node (N2) in response to the level of the first node (N1) and the first clock signal; an output control circuit (1044) controls the level of the output end under the control of the level of the second node (N2), and comprises an output control transistor (T4); the direction parallel to the direction from the non-display area (102B) to a display area (102) is a first direction (D1), and the shift register unit (104) comprises a first output semiconductor portion (A11) and a second output semiconductor portion (A12) which are spaced apart from each other in a second direction (D2), wherein the entire unit composed of the first output semiconductor portion (A11) and the second output semiconductor portion (A12) comprises an active layer of the output control transistor (T4) and an active layer of the output transistor (T5); and the lengthwise direction of a channel of the output control transistor (T4) and the lengthwise direction of a channel of the output transistor (T5) are both in the first direction (D1).

## Description

### TECHNICAL FIELD

Embodiments of the present disclosure relate to a display substrate and a display device.

### BACKGROUND

In the field of display technology, a pixel array of, for example, a liquid crystal display panel or an organic light emitting diode (OLED) display panel usually includes a plurality of rows of gate lines and a plurality of columns of data lines intersecting with the gate lines. Driving of the gate lines may be implemented through a bound integrated driving circuit. In recent years, with continuous improvement of a fabrication process of an amorphous silicon thin film transistor or an oxide thin film transistor, a gate driving circuit may also be directly integrated onto a thin film transistor array substrate to form a gate driver on array (GOA) to drive the gate lines. For example, a GOA including a plurality of cascaded shift register units may be used to supply a switch state voltage signal (a scan signal) to a plurality of rows of gate lines of a pixel array, so as to, for example, control sequentially turning on the plurality of rows of gate lines and simultaneously, by a data line, a data signal is supplied to a corresponding row of pixel units in the pixel array to form a grayscale voltage required for displaying respective grayscales of an image in the respective pixel units, and thereby a frame of image can be displayed.

### SUMMARY

At least one embodiment of the present disclosure provides a display substrate, including: a base substrate and a shift register unit. The base substrate includes a display region and a non-display region at least partially around the display region; the shift register unit is arranged on the base substrate and located in the non-display region; the shift register unit includes an input circuit, an output circuit, a first control circuit, and an output control circuit; the input circuit is configured to input an input signal to a first node in response to a first clock signal; the output circuit is configured to output an output signal to an output terminal; the first control circuit is configured to control a level of a second node in response to a level of the first node and the first clock signal; the output control circuit is configured to control a level of the output terminal under control of the level of the second node; the output control circuit includes an output control transistor, the output circuit includes an output transistor; a direction parallel to a direction from the non-display region to the display region is a first direction; the shift register unit includes a first output semiconductor portion and a second output semiconductor portion spaced apart from each other in a second direction; the second direction intersects with the first direction; an integral structure composed of the first output semiconductor portion and the second output semiconductor portion includes an active layer of the output control transistor and an active layer of the output transistor; a length direction of a channel of the output control transistor and a length direction of a channel of the output transistor are both along the first direction.

For example, in the display substrate provided by at least one embodiment of the present disclosure, the input circuit comprises an input transistor, and the first control circuit comprises a first control transistor and a second control transistor, an active layer of the input transistor, an active layer of the first control transistor, and an active layer of the second control transistor are all located on a first side of the integral structure composed of the first output semiconductor portion and the second output semiconductor portion in the second direction.

For example, in the display substrate provided by at least one embodiment of the present disclosure, the shift register unit further comprises a second control circuit, the second control circuit is connected with the first node and the second node, and is configured to control the level of the first node under control of the level of the second node and the second clock signal; the second control circuit comprises a first denoising transistor and a second denoising transistor, an active layer of the first denoising transistor and an active layer of the second denoising transistor are both located on the first side of the integral structure composed of the first output semiconductor portion and the second output semiconductor portion in the second direction.

For example, in the display substrate provided by at least one embodiment of the present disclosure, the active layer of the output control transistor and the active layer of the output transistor respectively comprise a plurality of sub-channel regions, and each of the output control transistor and the output transistor comprises at least one first sub-channel region and at least one second sub-channel region; the at least one first sub-channel region of the output control transistor and the at least one first sub-channel region of the output transistor are located in the first output semiconductor portion and are arranged along the first direction; the at least one second sub-channel region of the output control transistor and the at least one second sub-channel region of the output transistor are located in the second output semiconductor portion and are arranged along the first direction.

For example, in the display substrate provided by at least one embodiment of the present disclosure, a length of the first output semiconductor portion in the first direction is greater than a length of the first output semiconductor portion in the second direction; and a length of the second output semiconductor portion in the first direction is greater than a length of the second output semiconductor portion in the second direction.

For example, in the display substrate provided by at least one embodiment of the present disclosure, the output control circuit further comprises a first capacitor; a first electrode of the first capacitor is electrically connected with the second node, the display substrate further comprises a first power line; the first power line is configured to supply a first voltage to the shift register unit, and a second electrode of the first capacitor is electrically connected with the first power line; the first capacitor is located on the first side of the integral structure composed of the first output semiconductor portion and the second output semiconductor portion in the second direction.

For example, in the display substrate provided by at least one embodiment of the present disclosure, in the second direction, the first capacitor is located between the active layer of the first denoising transistor and the integral structure composed of the first output semiconductor portion and the second output semiconductor portion; the first electrode of the first capacitor is electrically connected with a gate electrode of the first denoising transistor and a gate electrode of the output control transistor, and the first electrode of the first capacitor, the gate electrode of the first denoising transistor and the gate electrode of the output control transistor compose a continuous integral structure; an electrode in which the gate electrode of the output control transistor is located extends along the second direction from the first electrode of the first capacitor towards the integral structure composed of the first output semiconductor portion and the second output semiconductor portion; an orthographic projection of the gate electrode of the output control transistor on the base substrate at least partially overlaps with an orthographic projection of the first output semiconductor portion on the base substrate, and at least partially overlaps with an orthographic projection of the second output semiconductor portion on the base substrate; an electrode in which the gate electrode of the first denoising transistor is located extends along the second direction from the first electrode of the first capacitor towards the active layer of the first denoising transistor, and an orthographic projection of the electrode in which the gate electrode of the first denoising transistor is located on the base substrate at least partially overlaps with an orthographic projection of the active layer of the first denoising transistor on the base substrate.

For example, in the display substrate provided by at least one embodiment of the present disclosure, the first power line extends along the second direction as a whole, and the first power line is located on a first side of an integral structure composed of the active layer of the input transistor, the active layer of the first control transistor, the active layer of the second control transistor, and the active layer of the second denoising transistor in the first direction; an orthographic projection of the first power line on the base substrate overlaps with an orthographic projection of the second electrode of the first capacitor on the base substrate, and the first power line is electrically connected with the second electrode of the first capacitor through a first via; and, the first power line and a first electrode of the output control transistor compose an integral structure, an orthographic projection of the first power line on the base substrate overlaps with both the orthographic projection of the first output semiconductor portion on the base substrate and the orthographic projection of the second output semiconductor portion on the base substrate, and the first power line is electrically connected with the first output semiconductor portion and the second output semiconductor portion through a second via.

For example, in the display substrate provided by at least one embodiment of the present disclosure, the first power line covers at least a portion of an edge of the first output semiconductor portion that extends along the second direction and at least a portion of an edge of the second output semiconductor portion that extends along the second direction.

For example, in the display substrate provided by at least one embodiment of the present disclosure, the output circuit further comprises a second capacitor, a first electrode of the second capacitor is connected with a control terminal of the output circuit; and a second electrode of the second capacitor is connected with the output terminal; the second capacitor is located on a side of the integral structure composed of the first output semiconductor portion and the second output semiconductor portion in the first direction.

For example, in the display substrate provided by at least one embodiment of the present disclosure, a length of the second capacitor in the second direction is greater than a length of the second capacitor in the first direction.

For example, in the display substrate provided by at least one embodiment of the present disclosure, an orthographic projection of the active layer of the second control transistor T3 on a plane parallel to the first direction at least partially overlaps with an orthographic projection of the active layer of the input transistor T1 on the plane parallel to the first direction, and at least partially overlaps with an orthographic projection of the second capacitor on the plane parallel to the first direction.

For example, in the display substrate provided by at least one embodiment of the present disclosure, the active layer of the input transistor, the active layer of the first denoising transistor, and the active layer of the second denoising transistor are arranged in the first direction; and the active layer of the input transistor, the active layer of the first control transistor, and the active layer of the second control transistor are arranged in the second direction.

For example, in the display substrate provided by at least one embodiment of the present disclosure, in the first direction, a space is between the active layer of the input transistor and the active layer of the second denoising transistor, and at least a portion of the active layer of the first control transistor overlaps with the space in the second direction; a first electrode of the input transistor and a first electrode of the second denoising transistor are both connected with the first node, the first electrode of the input transistor and the first electrode of the second denoising transistor compose a continuous integral first connection electrode, the first connection electrode is at least partially located in the space, and an electrode in which a gate electrode of the first control transistor is located extends through the space to be electrically connected with the first connection electrode.

For example, in the display substrate provided by at least one embodiment of the present disclosure, each selected from a group consisting of the active layer of the input transistor, the active layer of the second denoising transistor, and the first connection electrode is in a strip shape extending along the first direction; two ends of the first connection electrode in the first direction are respectively electrically connected with an end of the active layer of the input transistor and an end of the active layer of the second denoising transistor that are opposite to each other in the first direction.

For example, in the display substrate provided by at least one embodiment of the present disclosure, the shift register unit further comprises a voltage stabilizing circuit, the voltage stabilizing circuit is connected with the first node and the third node, and is configured to stabilize a level of the third node; the control terminal of the output circuit is connected with the third node, and the output circuit is configured to output the output signal to the output terminal under control of the level of the third node; the voltage stabilizing circuit comprises a voltage stabilizing transistor, an active layer of the voltage stabilizing transistor and the second capacitor are both located on the first side of the integral structure composed of the first output semiconductor portion and the second output semiconductor portion in the first direction, and orthographic projections of the active layer of the voltage stabilizing transistor and the second capacitor on a plane parallel to the second direction both overlap at least partially with the orthographic projection of the integral structure composed of the first output semiconductor portion and the second output semiconductor portion on the plane parallel to the second direction; the active layer of the voltage stabilizing transistor is located on a side of the second capacitor that is close to the input transistor in the second direction, and an orthographic projection of the active layer of the voltage stabilizing transistor on the plane parallel to the first direction at least partially overlaps with an orthographic projection of the second capacitor on the plane parallel to the first direction.

For example, in the display substrate provided by at least one embodiment of the present disclosure, the voltage stabilizing transistor is located on a side of the first control transistor that is close to the second capacitor in the second direction, and a first electrode of the voltage stabilizing transistor is electrically connected with the first electrode of the second capacitor; an orthographic projection of the voltage stabilizing transistor on the plane parallel to the first direction does not overlap with an orthographic projection of the first control transistor on the plane parallel to the first direction, and overlaps with an orthographic projection of the second control transistor on the plane parallel to the first direction.

For example, in the display substrate provided by at least one embodiment of the present disclosure, an electrode in which the gate electrode of the first control transistor is located comprises a tilt portion, an extension direction of the tilt portion intersects with both the first direction and the second direction, and an end of the tilt portion that is close to the voltage stabilizing transistor in the second direction is electrically connected with the second electrode of the voltage stabilizing transistor through a third via.

For example, in the display substrate provided by at least one embodiment of the present disclosure, the electrode in which the gate electrode of the first control transistor is located further comprises a vertical portion connected with the tilt portion and extending along the second direction, the vertical portion extends through the space, and an end of the vertical portion that is away from the tilt portion in the second direction is electrically connected with the first connection electrode through a fourth via.

For example, in the display substrate provided by at least one embodiment of the present disclosure, a gate electrode of the second denoising transistor and a first electrode of the output transistor are both electrically connected with a second clock signal terminal to receive the second clock signal; an electrode in which the gate electrode of the second denoising transistor is located is in a strip shape extending along the second direction, the first electrode of the output transistor comprises a second connection electrode, the second connection electrode comprises a first strip portion extending along the first direction, an end close to the output transistor in the second direction of the electrode in which the gate electrode of the second denoising transistor is located is electrically connected with a first end of the first strip portion in the first direction through a fifth via, and the second connection electrode is electrically connected with the second clock signal terminal.

For example, in the display substrate provided by at least one embodiment of the present disclosure, the display substrate further comprises an output signal line electrically connected with the output terminal, and a portion of the output signal line that is located in the non-display region comprises a first-direction portion and a second-direction portion; the first-direction portion of the output signal line extends along the first direction, an end of the first-direction portion that is away from the display region in the first direction is electrically connected with an electrode in which a second electrode of the output transistor is located through a first output via, so that the second electrode of the output transistor is electrically connected with the output terminal; the second-direction portion of the output signal line is connected with the first-direction portion, is located on a side of the first-direction portion that is close to the display region, and extends along the second direction as a whole to further enter the display region.

For example, in the display substrate provided by at least one embodiment of the present disclosure, the electrode in which the second electrode of the output transistor is located comprises a strip-shaped main body portion extending along the first direction, a plurality of strip-shaped extending portions that are connected with the strip-shaped main body portion, located on a first side of the strip-shaped main body portion in the second direction, spaced apart from each other and extend along the second direction, and a protrusion portion protruding from the strip-shaped main body portion towards a direction away from the plurality of strip-shaped extending portions in the second direction; orthographic projections of the plurality of strip-shaped extending portions on the base substrate overlaps at least partially with both the orthographic projection of the first output semiconductor portion on the base substrate and the orthographic projection of the second output semiconductor portion on the base substrate, and the protrusion portion is located on a second side of the integral structure composed of the first output semiconductor portion and the second output semiconductor portion opposite to the first side of the integral structure composed of the first output semiconductor portion and the second output semiconductor portion in the second direction; the first-direction portion of the output signal line is located on the second side of the integral structure composed of the first output semiconductor portion and the second output semiconductor portion in the second direction, an end of the first-direction portion that is away from the display region in the first direction is connected with the protrusion portion through the first output via, and the second-direction portion is connected with the first-direction portion, located on a side of the first-direction portion that is close to the display region, and extends along the second direction as a whole.

For example, in the display substrate provided by at least one embodiment of the present disclosure, the first power line is located on a side of the second electrode of the output transistor that is close to the display region in the first direction, and an orthographic projection of the first power line on the base substrate overlaps with an orthographic projection of the output signal line on the base substrate.

For example, the display substrate provided by at least one embodiment of the present disclosure further comprises a second power line, a trigger signal line, a first clock signal line and a second clock signal line. The second power line is configured to supply a second voltage to the shift register unit, wherein a first electrode of the second control transistor is connected with the second node, and a second electrode of the second control transistor is connected with the second power line to receive the second voltage; the display substrate comprises a plurality of cascaded shift register units, a first electrode of an input transistor in a first-stage shift register unit is connected with the input terminal, and the input terminal is configured to be connected with the trigger signal line to receive a trigger signal from the trigger signal line as an input signal; the first clock signal line is configured to supply the first clock signal to the shift register unit; and the second clock signal line is configured to supply the second clock signal to the shift register unit, the second power line, the trigger signal line, the first clock signal line, the second clock signal line, and the first power line are all arranged in a same layer as the second electrode of the second control transistor.

For example, in the display substrate provided by at least one embodiment of the present disclosure, the second capacitor is located on a side of the integral structure composed of the first output semiconductor portion and the second output semiconductor portion that is close to the display region in the first direction; the display substrate further comprises an output signal line; the output signal line is electrically connected with the second electrode of the second capacitor; the second electrode of the second capacitor is electrically connected with the electrode in which the second electrode of the output transistor is located through a second output via, so that the second electrode of the output transistor is electrically connected with the output terminal.

For example, in the display substrate provided by at least one embodiment of the present disclosure, the display substrate further comprises a second power line, a trigger signal line, a first clock signal line and a second clock signal line. The second power line is configured to supply a second voltage to the shift register unit, the first electrode of the second control transistor is connected with the second node, and the second electrode of the second control transistor is connected with the second power line to receive the second voltage; the display substrate comprises a plurality of cascaded shift register units, a first electrode of an input transistor in a first-stage shift register unit is connected with the input terminal, and the input terminal is configured to be connected with the trigger signal line to receive a trigger signal from the trigger signal line as an input signal; the first clock signal line is configured to supply the first clock signal to the shift register unit; and the second clock signal line is configured to supply the second clock signal to the shift register unit; at least one selected from a group consisting of the second power line, the trigger signal line, the first clock signal line, and the second clock signal line overlaps with the shift register unit in a direction perpendicular to the base substrate and is arranged in a layer different from the second electrode of the second control transistor.

For example, in the display substrate provided by at least one embodiment of the present disclosure, the second power line extends along the second direction as a whole, at least partially overlaps with the electrode in which the gate electrode of the second control transistor is located in the direction perpendicular to the base substrate, and at least partially overlaps with the second electrode of the second control transistor in the direction perpendicular to the base substrate; the second power line and the second electrode of the second control transistor are arranged in different layers, the second electrode of the second control transistor is located between the second power line and the electrode in which the gate electrode of the second control transistor is located, the second electrode of the second control transistor comprises a portion not overlapping with the electrode in which the gate electrode of the second control transistor is located in the direction perpendicular to the base substrate, the second power line is electrically connected with the second electrode of the second control transistor through a first power via, and the second electrode of the second control transistor is electrically connected with the active layer of the second control transistor through a first auxiliary via.

For example, in the display substrate provided by at least one embodiment of the present disclosure, the shift register unit further comprises a voltage stabilizing circuit, the voltage stabilizing circuit is connected with the first node and the third node, and is configured to stabilize the level of the third node; the control terminal of the output circuit is connected with the third node; the output circuit is configured to output the output signal to the output terminal under control of the level of the third node; the voltage stabilizing circuit comprises a voltage stabilizing transistor, an active layer of the voltage stabilizing transistor and the second capacitor are both located on the first side of the integral structure composed of the first output semiconductor portion and the second output semiconductor portion in the first direction; and the second power line at least partially overlaps with an electrode in which the gate electrode of the voltage stabilizing transistor is located in the direction perpendicular to the base substrate, and the second power line is electrically connected with the electrode in which the gate electrode of the voltage stabilizing transistor is located through a second power via.

For example, in the display substrate provided by at least one embodiment of the present disclosure, the second power line further at least partially overlaps with the input transistor and the second capacitor in the direction perpendicular to the base substrate.

For example, in the display substrate provided by at least one embodiment of the present disclosure, the trigger signal line extends along the second direction and at least partially overlaps with the first electrode of the input transistor of the first-stage shift register unit in the direction perpendicular to the base substrate, and the trigger signal line is electrically connected with the first electrode of the input transistor of the first-stage shift register unit through a trigger via.

For example, in the display substrate provided by at least one embodiment of the present disclosure, the first clock signal line extends along the second direction as a whole and at least partially overlaps with an electrode in which the gate electrode of the input transistor and a gate electrode of the second control transistor are located in the direction perpendicular to the base substrate, and the first clock signal line is electrically connected with the electrode in which the gate electrode of the input transistor and the gate electrode of the second control transistor of the first-stage shift register unit are located through a first clock via.

For example, in the display substrate provided by at least one embodiment of the present disclosure, the second clock signal line extends along the second direction and at least partially overlaps with an electrode in which a first electrode of the output transistor is located in the direction perpendicular to the base substrate, and the second clock signal line is electrically connected with the electrode in which the first electrode of the output transistor is located through a second clock via.

For example, in the display substrate provided by at least one embodiment of the present disclosure, an electrode in which a gate electrode of the second denoising transistor is located is in a strip shape extending along the second direction, the first electrode of the output transistor comprises a second connection electrode, the second connection electrode comprises a first strip portion extending along the first direction, an end close to the output transistor in the second direction of the electrode in which the gate electrode of the second denoising transistor is located is electrically connected with a first end of the first strip portion in the first direction through a fifth via, and the second connection electrode is electrically connected with the second clock signal terminal, the second clock signal line at least partially overlaps with the first strip portion in the direction perpendicular to the base substrate, and the second clock signal line is electrically connected with the first strip portion through the second clock via, so that the gate electrode of the second denoising transistor and the first electrode of the output transistor are both connected with the second clock signal terminal.

For example, in the display substrate provided by at least one embodiment of the present disclosure, the second power line, the trigger signal line, the first clock signal line, and the second clock signal line all overlap with the shift register unit in the direction perpendicular to the base substrate; the second power line, the trigger signal line, the first clock signal line, and the second clock signal line are arranged in a same layer, and are all arranged in a layer different from the first electrode of the output transistor.

At least one embodiment of the present disclosure further provides a display device, and the display device includes any one of the display substrates provided by the embodiments of the present disclosure.

For example, in the display device provided by at least one embodiment of the present disclosure, the display device further comprises a plurality of pixel units located in the display region and arranged in an array, at least a part of the plurality of pixel units comprise a light emitting device, the output signal output by the output circuit of the shift register unit serves as a gate scan signal to drive the light emitting devices of the plurality of pixel units to emit light.

### BRIEF DESCRIPTION OF DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
Fig. 1A is a schematic diagram of an integral circuit architecture of a display panel provided by an embodiment of the present disclosure;
Fig. 1B is a circuit diagram of a shift register unit provided by an embodiment of the present disclosure;
Fig. 1C is a signal timing diagram of operation of the shift register unit shown in Fig. 1B;
Fig. 2 is a schematic diagram of layout of a portion of a display substrate that includes a shift register unit provided by at least one embodiment of the present disclosure;
Fig. 3A to Fig. 3G respectively show planar structural schematic diagrams of respective layers of the shift register unit of the display substrate shown in Fig. 2;
Fig. 4 is a cross-sectional schematic diagram along an A1-A2 line in Fig. 2;
Fig. 5A is a schematic diagram of layout of a portion of another display substrate that includes a shift register unit provided by at least one embodiment of the present disclosure;
Fig. 5B to Fig. 5D are schematic diagrams of some layers in Fig. 5A;
Fig. 6A is a cross-sectional schematic diagram along a B1-B2 line in Fig. 5A;
Fig. 6B is a cross-sectional schematic diagram along a C1-C2 line in Fig. 5A;
Fig. 7 is a schematic diagram of layout of a portion of another display substrate that includes a shift register unit provided by at least one embodiment of the present disclosure;
Fig. 8A to Fig. 8G respectively show planar structural schematic diagrams of respective layers of the shift register unit of the display substrate shown in Fig. 7;
Fig. 9A is a cross-sectional schematic diagram along a D1-D2 line in Fig. 7;
Fig. 9B is a cross-sectional schematic diagram along an E1-E2 line in Fig. 7;
Fig. 10 is a schematic diagram of layout of a portion of another display substrate that includes a shift register unit provided by at least one embodiment of the present disclosure; and
Fig. 11 is a schematic diagram of a display device provided by at least one embodiment of the present disclosure.

### DETAILED DESCRIPTION

In order to make objects, technical details and advantages of the embodiments of the disclosure apparent, the technical solutions of the embodiments will be described in a clear and fully understandable way in connection with the drawings related to the embodiments of the disclosure. Apparently, the described embodiments are just a part but not all of the embodiments of the disclosure. Based on the described embodiments herein, those skilled in the art can obtain other embodiment (s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprise," "comprising," "comprise," "comprising," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may comprise an electrical connection, directly or indirectly. "On," "under," "left," "right" and the like are only used to indicate relative position relationship, and when the position of the object which is described is changed, the relative position relationship may be changed accordingly.

It should be noted that the term "first direction" according to the present disclosure refers to a direction parallel to a direction from a non-display region to a display region, that is, the first direction is not limited to the direction from the non-display region to the display region, but also includes a direction from the display region to the non-display region.

For a driving circuit of a display panel, for example, a GOA driving circuit, either double-sided driving or single-sided driving may be adopted, for example, one GOA unit driving two rows of pixels. Taking double-sided driving as an example, a GOA circuit is usually designed to be arranged on two opposite sides of the display region, that is, on two opposite sides of a pixel circuit in the display region; and cascaded GOA units include a lot of capacitors, thin film transistors, and signal lines, which occupy a lot of space. Therefore, placement position of devices and common signal traces need to be reasonably designed, to reduce space occupied by the GOA units and facilitate narrowing a border of the display panel, especially a small-sized display panel which has higher requirements on a degree of border narrowing.

At least one embodiment of the present disclosure provides a display substrate, including: a base substrate and a shift register unit. The base substrate includes a display region and a non-display region at least partially around the display region; the shift register unit is arranged on the base substrate and located in the non-display region; the shift register unit includes an input circuit, an output circuit, a first control circuit, and an output control circuit; the input circuit is configured to input an input signal to a first node in response to a first clock signal; the output circuit is configured to output an output signal to an output terminal; the first control circuit is configured to control a level of a second node in response to a level of the first node and the first clock signal; the output control circuit is configured to control a level of the output terminal under control of the level of the second node; the output control circuit includes an output control transistor, the output circuit includes an output transistor; a direction parallel to a direction from the non-display region to the display region is a first direction; the shift register unit includes a first output semiconductor portion and a second output semiconductor portion spaced apart from each other in a second direction; the second direction intersects with the first direction; an integral structure composed of the first output semiconductor portion and the second output semiconductor portion includes an active layer of the output control transistor and an active layer of the output transistor; a length direction of a channel of the output control transistor and a length direction of a channel of the output transistor are both along the first direction.

At least one embodiment of the present disclosure further provides a display device, including any one of the display substrates provided by the embodiments of the present disclosure.

The display substrate provided by the above-described embodiments of the present disclosure have line connection and structural layout of the shift register unit optimized, which reduces a width of the shift register unit in the first direction, and is favorable for implementing narrow border design of the display panel; moreover, sufficient space in the second direction may be utilized to increase channel widths (W) of the output control transistor and the output transistor, so as to increase width/length ratios (W/L) of the output control transistor and the output transistor, and at a same time, ensure display quality of the display panel.

It should be noted that in a width/length W/L of a transistor, W represents a channel width, which refers to a channel length in a direction perpendicular to a current direction from a source electrode to a drain electrode in the transistor; and L represents a channel length, which refers to a channel length in a same direction as the current direction.

Hereinafter, the present disclosure will be illustrated through several specific embodiments. In order to keep the following illustration of the embodiments of the present disclosure clear and concise, detailed illustration of known functions and known components may be omitted. When any component according to the embodiments of the present disclosure appears in more than one diagram, the component may be represented by a same reference sign in each diagram.

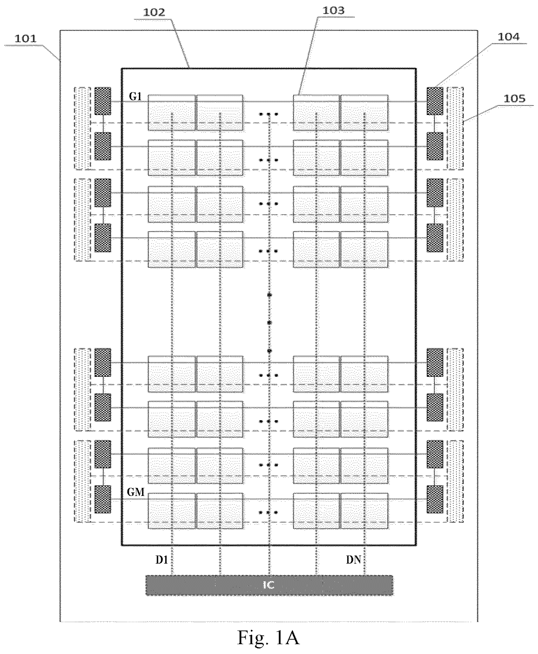

Fig. 1A is a schematic diagram of an integral circuit architecture of a display panel provided by an embodiment of the present disclosure. For example, as shown in Fig. 1A, 101 represents an integral outer border line of the display panel; the display panel includes a display region (i.e., a pixel array region) 102 and a peripheral region 102B located in the peripheral of the display region 102; the display region includes pixel units 103 arranged in an array; the peripheral region 102B includes a shift register unit 104; a plurality of cascaded shift register units 104 form a gate driving circuit for supplying, for example, a row-by-row shift gate scan signal to the pixel units 103 arranged in an array in the display region 102 of the display panel 101; the peripheral region 102B further includes a light emission control unit 105; a plurality of cascaded light emission control units 105 compose a light emission control array for supplying, for example, a row-by-row shift light emission control signal, to the pixel units 103 arranged in an array in the display region 102 of the display panel 101.

For example, the shift register unit 104 provided by the embodiment of the present disclosure is a gate driver on array (GOA) unit.

As shown in Fig. 1A, data lines D1 to DN (N being an integer greater than 1) connected with a data driver chip IC pass through the display region 102 in the second direction to supply a data signal to the pixel units 103 arranged in an array; gate lines G1 to GM (M being an integer greater than 1) connected with the shift register units 104 and the light emission control units 105 cross the display region 102 to supply a gate scan signal and a light emission control signal to the pixel units arranged in an array. For example, each pixel unit 103 may include a pixel circuit having a circuit structure such as 7T1C, 8T2C or 4T1C, etc. in the art and a light emitting element; the pixel circuit operates under control of the data signal transmitted through the data line as well as the gate scan signal and the light emission control signal transmitted through the gate line, to drive the light emitting element to emit light and implement operations such as display. The light emitting element may be, for example, an organic light emitting diode (OLED) or a quantum dot light emitting diode (QLED).

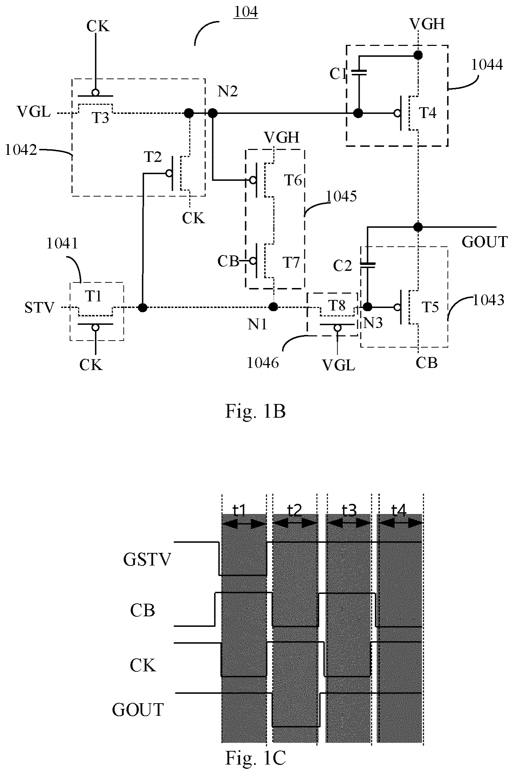

Fig. 1B is a circuit diagram of a shift register unit provided by an embodiment of the present disclosure. For example, as shown in Fig. 1B, the shift register unit 104 includes an input circuit 1041, an output circuit 1043, a first control circuit 1042, and an output control circuit 1044; in other examples, the shift register unit 104 further includes a second control circuit 1045 and a voltage stabilizing circuit 1046.

The input circuit 1041 is configured to input an input signal to a first node N1 in response to a first clock signal. For example, the input circuit 1041 is connected with an input terminal IN, a first node N1, and a first clock signal terminal CK, and is configured to be turned on under control of the first clock signal received by the first clock signal terminal CK, and connect the input terminal IN with the first node N1, so as to input the input signal to the first node N1. For example, the input circuit 1041 is implemented as an input transistor T1 as described below.

The output circuit 1043 is configured to output an output signal to an output terminal GOUT. For example, the output circuit 1043 is connected with a third node N3, the output terminal GOUT, and a second clock signal terminal CB, and is configured to be turned on under control of a level of the third node N3, so that the second clock signal terminal CB is connected with the output terminal GOUT, so as to output a second clock signal at the output terminal GOUT, for example, output a low level of the second clock signal. For example, the output circuit 1043 is implemented as an output transistor T5 and a second capacitor C2 as described below.

The first control circuit 1042 is configured to control a level of the second node N2 in response to a level of the first node N1 and the first clock signal. For example, the first control circuit is connected with the first node N1, the second node N2, and the first clock signal terminal CK, and is configured to be turned on under control of the level of the first node N1, so that the second node N2 is connected with the first clock signal terminal CK, so as to supply the first clock signal supplied by the first clock signal terminal CK to the second node N2. For example, the first control circuit 1042 is implemented as a first control transistor T2 and a second control transistor T3 as described below. It should be noted that the first control circuit 1042 is not limited to being connected with the first node N1, but may also be connected with other independent voltage ends (supplying a voltage the same as the voltage of the first node N1) or be connected with a separately provided circuit that is the same as the input circuit, which will not be limited in the embodiments of the present disclosure. Connections of other circuits of the shift register unit are similar thereto, and no details will be repeated here.

The output control circuit 1044 is configured to control a level of the output terminal GOUT under control of the level of the second node N2. For example, the output control circuit 1044 is connected with the second node N2, the first power line VGH, and the output terminal GOUT, and is configured to connect the output terminal GOUT and the first power line VGH, under control of the level of the second node N2, so as to output a first voltage supplied by the first power line VGH to the output terminal GOUT, to control the output terminal GOUT at a high level, thereby avoiding erroneous output of the shift register unit in a non-output stage. For example, the output control circuit 1044 is implemented as an output control transistor T4 and a first capacitor C1 as described below.

The second control circuit 1045 is connected with the first node N1 and the second node N2, and is configured to control the level of the first node N1 under control of the level of the second node N2 and the second clock signal. The second control circuit 1045 is connected with the first node N1, the second node N2, the first power line VGH, and the second clock signal terminal CB, and is configured to be turned on under control of the level of the second node N2 and the second clock signal received by the second clock signal terminal CB, so that the first power line VGH is connected with the first node N1, so as to charge a potential of the first node N1 to a high level, thereby avoiding turning on the output circuit 1042 in a non-output stage and avoiding erroneous output. For example, the second control circuit 1045 is implemented as a first denoising transistor T6 and a second denoising transistor T7 as described below.

The voltage stabilizing circuit 1046 is connected with the first node N1 and the third node N3, and is configured to stabilize the level of the third node N3. For example, the voltage stabilizing circuit 1046 is connected with the first node N1, the third node N3, and the second power line VGL, and is configured to be turned on under control of a second voltage supplied by the second power line VGL, so that the first node N1 and the third node N3 are electrically connected with each other. For example, the voltage stabilizing circuit 1046 is implemented as a voltage stabilizing transistor T8 as described below.

For example, the voltage stabilizing transistor T8 is always in an ON state under control of the second voltage supplied by the second power line VGL, so that the third node N3 is electrically connected with the first node N1 through the voltage stabilizing transistor T8, thereby preventing the level of the third node N3 from leaking through the input transistor T1, the first control transistor T2, and the second denoising transistor T7 connected with the first node N1, and meanwhile, stress of the level of the third node N3 on the first control transistor T1 may also be reduced, which is favorable for keeping the level of the third node N3, so that the output transistor T5 is fully turned on in an output stage.

UP. In the following, an operation process of the shift register unit will be briefly introduced, in conjunction with Fig. 1B and Fig. 1C.

As shown in Fig. 1B, the shift register unit 104 includes 8 transistors (the input transistor T1, the first control transistor T2, the second control transistor T3, the output control transistor T4, the output transistor T5, the first denoising transistor T6, the second denoising transistor T7, and the voltage stabilizing transistor T8) and 2 capacitors (the first capacitor C1 and the second capacitor C2). For example, the input circuit 1041 includes the input transistor T1; the first control circuit 1042 includes the first control transistor T2 and the second control transistor T3; the output control circuit 1044 includes the output control transistor T4 and the first capacitor C1; the output circuit 1043 includes the output transistor T5 and the second capacitor C2; the second control circuit 1045 includes the first denoising transistor T6 and the second denoising transistor T7; and the voltage stabilizing circuit 1046 includes the voltage stabilizing transistor T8.

For example, when a plurality of shift register units 104 are cascaded, a first electrode of an input transistor T1 in a first-stage shift register unit 104 is connected with the input terminal IN; the input terminal IN is configured to be connected with a trigger signal line GSTV to receive a trigger signal as the input signal, while first electrodes of input transistors T1 in other respective stages of shift register units 104 are electrically connected with an output terminal of a previous stage of shift register unit 104, to receive an output signal output by the output terminal GOUT of the previous stage of shift register unit 104 as the input signal, thereby implementing shift output, for example, for use in row-by-row scanning of the array of pixel units in the active display region.

In addition, as shown in Fig. 1B, the shift register unit further includes a first clock signal terminal CK and a second clock signal terminal CB, where, GCK represents a first sub-clock signal line and GCB represents a second sub-clock signal line. For example, when the first clock signal terminal CK is connected with the first sub-clock signal line GCK to receive the first clock signal, the first sub-clock signal line GCK is a first clock signal line; and when the first clock signal terminal CK is connected with the second sub-clock signal line GCB to receive the first clock signal, the second sub-clock signal line GCB is a first clock signal line, depending on specific situations, which will not be limited in the embodiments of the present disclosure. The second clock signal terminal CB is connected with the second sub-clock signal line GCB or the first sub-clock signal line GCK to receive the second clock signal. Hereinafter, introduction is given by taking that the first clock signal terminal CK is connected with the first sub-clock signal line GCK to receive the first clock signal, and the second clock signal terminal CB is connected with the second sub-clock signal line GCB to receive the second clock signal, that is, the first sub-clock signal line GCK serves as the first clock signal line and the second sub-clock signal line GCB serves as the second clock signal line as an example, which will not be limited in the embodiments of the present disclosure. For example, the first clock signal GCK and the second clock signal GCB may adopt a pulse signal with a duty cycle greater than 50%, and the two differ by half a cycle, for example; VGH represents the first power line and a first voltage supplied by the first power line, for example, the first voltage is a direct-current high level, VGL represents the second power line and a second voltage supplied by the second power line, for example, the second voltage is a direct-current low level, and the first voltage is greater than the second voltage; where, N1, N2 and N3 respectively represent the first node, the second node, and the third node in the circuit schematic diagram.

As shown in Fig. 1B, a gate electrode of the input transistor T1 is connected with the first clock signal terminal CK (the first clock signal terminal CK is connected with the first sub-clock signal line GCK) to receive the first clock signal; a second electrode of the input transistor T1 is connected with the input terminal IN; and a first electrode of the input transistor T1 is connected with the first node N1. For example, when the shift register unit is the first-stage shift register unit, the input terminal IN is connected with the trigger signal line GSTV to receive the trigger signal; when the shift register unit is any other stage of shift register unit except for the first-stage shift register unit, the input terminal IN is connected with the output terminal GOUT of a previous stage of shift register unit thereof.

A gate electrode of the first control transistor T2 is connected with the first node N1; a second electrode of the first control transistor T2 is connected with the first clock signal terminal CK to receive the first clock signal; and a first electrode of the first control transistor T2 is connected with the second node N2.

A gate electrode of the second control transistor T3 is connected with the first clock signal terminal CK to receive the first clock signal; a second electrode of the second control transistor T3 is connected with the second power line VGL to receive the second voltage; and a first electrode of the second control transistor T3 is connected with the second node N2.

A gate electrode of the output control transistor T4 is connected with the second node N2; a first electrode of output control transistor T4 is connected with the first power line VGH to receive the first voltage; and a second electrode of the output control transistor T4 is connected with the output terminal GOUT.

A first electrode of the first capacitor is connected with the second node N2; and a second electrode of the first capacitor C1 is connected with the first power line VGH.

A gate electrode of the output transistor T5 is connected with the third node N3; a first electrode of the output transistor T5 is connected with the second clock signal terminal CB; and a second electrode of the output transistor T5 is connected with the output terminal GOUT.

A first electrode of the second capacitor C2 is connected with the third node N3; and a second electrode of the second capacitor C2 is connected with the output terminal GOUT.

A gate electrode of the first denoising transistor T6 is connected with the second node N2; a first electrode of the first denoising transistor T6 is connected with the first power line VGH to receive the first voltage; and a second electrode of the first denoising transistor T6 is connected with a second electrode of the second denoising transistor T7.

A gate electrode of the second denoising transistor T7 is connected with the second clock signal terminal CB (the second clock signal terminal CB is connected with the second sub-clock signal line GCB) to receive the second clock signal; and a first electrode of the second denoising transistor T7 is connected with the first node N1.

A gate electrode of the voltage stabilizing transistor T8 is connected with the second power line VGL to receive the second voltage; a second electrode of the voltage stabilizing transistor T8 is connected with the first node N1; and a first electrode of the voltage stabilizing transistor T8 is connected with the third node N3.

The transistors in the shift register unit 104 shown in Fig. 1B are all illustrated by taking P-type transistors as an example, that is, the respective transistors are turned on when the gate electrodes are accessed to a low level (ON level), and are turned off when the gate electrodes are accessed to a high level (OFF level). For example, the first electrode of the transistor may be a source electrode, and the second electrode of the transistor may be a drain electrode.

The shift register unit includes, but is not limited to, the setting mode of Fig. 1B, for example, the respective transistors in the shift register unit 104 may also adopt N-type transistors or a mixture of P-type transistors and N-type transistors, as long as ports of transistors of a selected type are connected simultaneously according to port polarity of the corresponding transistors according to the embodiment of the present disclosure.

It should be noted that, the transistors adopted in the shift register unit may all be thin film transistors or field effect transistors or other switch devices with same characteristics. Here, all are illustrated by taking thin film transistors as an example, for example, an active layer (a channel region) of the transistor is made of a semiconductor material, for example, polysilicon (e.g., low-temperature polysilicon or high-temperature polysilicon), amorphous silicon, indium gallium tin oxide (IGZO), etc., while a gate electrode, a source electrode, and a drain electrode, etc. are made of metal materials, for example, metal aluminum or aluminum alloy. The source electrode and the drain electrode of the transistor adopted here may be symmetrical in structure, so the source electrode and the drain electrode thereof may be structurally indistinguishable. In the embodiment of the present disclosure, in order to distinguish the two electrodes of the transistor other than the gate electrode, one electrode is directly described as a first electrode and the other electrode as a second electrode. In addition, in the embodiment of the present disclosure, plates of the capacitor may be metal electrodes or one of the plates may be made of a semiconductor material (e.g., doped polysilicon).

Fig. 1C shows a signal timing diagram of operation of the shift register unit 104 shown in Fig. 1B. Hereinafter, the operation process of the shift register will be introduced in details in conjunction with Fig. 1B and Fig. 1C. For example, the operation principle will be illustrated by taking the first-stage shift register unit 104 as an example, operation principles of other stages of shift register units 104 are similar thereto, and no details will be repeated here. As shown in Fig. 1C, the operation process of the shift register unit 104 includes four stages, namely a first stage t1, a second stage t2, a third stage t3, and a fourth stage t4. Fig. 1C shows timing waveforms of respective signals in each stage.

In the first stage t1, as shown in Fig. 1C, the first clock signal terminal CK receives a low-level first clock signal, and the trigger signal line GSTV supplies a low-level trigger signal, so, the input transistor T1 and the second control transistor T3 are turned on, and the turned-on input transistor T1 transmits the low-level trigger signal to the first node N1, so that the level of the first node N1 becomes a low level, and the first control transistor T2 and the output transistor T5 are turned on; since the voltage stabilizing transistor T8 is always in an ON state in response to the second voltage (the low level) supplied by the second power line VGL, the level of the third node N3 is the same as the level of the first node N1, that is, the low level. Meanwhile, the low level is stored in the second capacitor C2. In addition, the turned-on second control transistor T3 transmits the low-level second voltage VGL to the second node N2, and the turned-on first control transistor T2 transmits the low level of the first clock signal to the second node N2, so that the level of the second node N2 becomes a low level and is stored in the first capacitor C1. Therefore, the output control transistor T4 is turned on in response to the low level of the second node N2, and outputs the high-level first voltage supplied by the first power line VGH to the output terminal GOUT; meanwhile, the output transistor T5 is turned on in response to the low level of the third node N3, and outputs the high-level second clock signal received by the second clock signal terminal CB to the output terminal GOUT; and in the stage, the shift register unit outputs a high level.

In the second stage t2, as shown in Fig. 1C, the second clock signal terminal CB receives a low-level second clock signal, so the second denoising transistor T7 is turned on; the first clock signal terminal CK receives a high-level first clock signal, so the input transistor T1 and the second control transistor T3 are turned off. Due to a storage function of the second capacitor C2, the first node N1 may continue keeping the low level of the previous stage, so the first control transistor T2 and output transistor T5 are turned on. Since the first control transistor T2 is turned on, the high-level first clock signal received by the first clock signal terminal CK is transmitted to the second node N2, the second node N2 becomes a high level, and the first denoising transistor T6 and the output control transistor T4 are turned off, thereby avoiding the high level supplied by the first power line VGH from being output to the output terminal GOUT and the first node N1. Meanwhile, since the output transistor T5 is turned on, in the stage, the output terminal GOUT outputs the low level received by the second clock signal terminal GB, for example, the low level is used for controlling operation of the pixel unit 103 shown in Fig. 1A.

In the third stage t3, as shown in Fig. 1C, the first clock signal terminal CK receives a low-level first clock signal, so the input transistor T1 and the second control transistor T3 are turned on. At this time, the high level supplied by the trigger signal line GSTV is transmitted to the first node N1 and the third node N3, so the output transistor T5 and the first control transistor T2 are turned off. The second clock signal terminal CB receives a high-level second clock signal, so the second denoising transistor T7 is turned off. Since the second control transistor T3 is turned on, the low level supplied by the second power line VGL is transmitted to the second node N2 and stored in the first capacitor C1, the output control transistor T4 and the first denoising transistor T6 are turned on; and in the stage, the output terminal GOUT outputs the high level supplied by the first power line VGH.

In the fourth stage t4, as shown in Fig. 1C, the first clock signal terminal CK receives a high-level first clock signal, so the input transistor T1 and the second control transistor T3 are turned off. The second clock signal terminal CB receives a low-level second clock signal, so the second denoising transistor T7 is turned on. Due to a storage function of the second capacitor C2, the level of the first node N1 keeps as the high level in the previous stage, so that the first control transistor T2 and the output transistor T5 are turned off. Due to a storage function of the first capacitor C1, the second node N2 continues keeping the low level of the previous stage, so that the first denoising transistor T6 is turned on, and the high level supplied by the first power line VGH is transmitted to the first node N1 and the third node N3 through the first denoising transistor T6 and the second denoising transistor T7 turned on, so that the first node N1 and the third node N3 continue keeping the high level, thereby effectively preventing the output transistor T5 from being turned on and avoiding erroneous output.

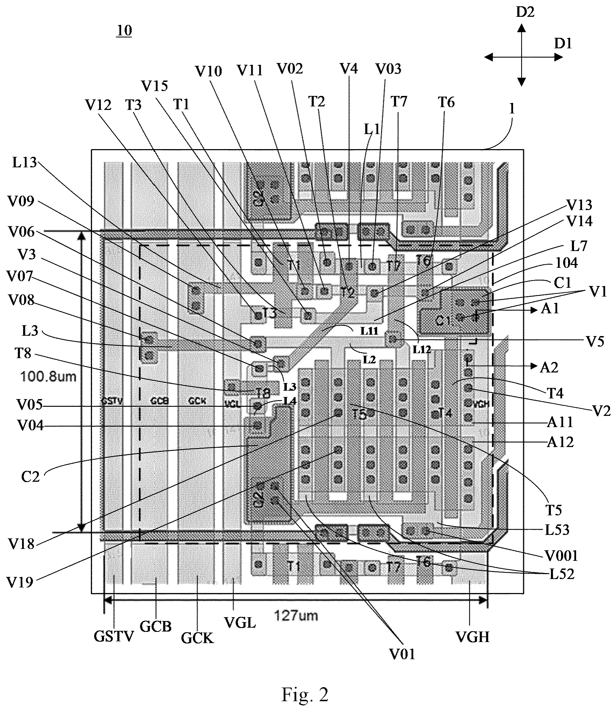

Fig. 2 is a schematic diagram of layout of a portion of a display substrate that includes a shift register unit 104 provided by at least one embodiment of the present disclosure.

Exemplarily, in conjunction with Fig. 1A, Fig. 1B and Fig. 2, the display substrate 10 provided by the embodiment of the present disclosure includes: a base substrate 1, and a shift register unit 104 arranged on the base substrate 1. The base substrate 1 includes a display region 102 and a non-display region 102B (i.e., a peripheral region 102B) at least partially around the display region 102; and the shift register unit 104 is arranged on the base substrate 1 and is located in the non-display region 102B.

For example, as shown in Fig. 2, the display substrate 10 further includes a first power line VGH, a second power line VGL, and a plurality of clock signal lines (e.g., a first clock signal line GCK, a second clock signal line GCB, and a trigger signal line GSTV shown in the diagram) arranged on the base substrate 10. For example, the first power line VGH, the second power line VGL, and the plurality of clock signal lines extend on the base substrate 10 along a second direction D2 shown in Fig. 2, and are configured to respectively supply a first voltage, a second voltage, and a plurality of clock signals (e.g., the trigger signal, the first clock signal, or the second clock signal, etc. as described above) to the shift register unit 104.

It should be noted that the first power line VGH, the second power line VGL, and the plurality of clock signal lines may be arranged in parallel along the second direction D2, or may also intersect with each other at a certain angle (e.g., less than or equal to 20 °); these lines are not limited to strict straight lines, or may also have portions bending to a certain degree, as long as the lines extend along the second direction D2 as a whole, which will not be limited in the embodiments of the present disclosures.

For example, the first power line VGH is configured to supply a first voltage to a plurality of cascaded shift register units 104 included in a scan driving circuit; and the second power line VGL is configured to supply a second voltage to the plurality of cascaded shift register units 104 included in the scan driving circuit. For example, the first voltage is greater than the second voltage, for example, the first voltage is a direct-current high level, and the second voltage is a direct-current low level.

For example, the display substrate 1 includes a pixel array region (i.e., the display region 102 shown in Fig. 1A, hereinafter referred to as a pixel array region 102) and a peripheral region 102B other than the pixel array region. For example, in some embodiments, the first power line VGH, the second power line VGL, the plurality of clock signal lines, and the shift register unit 104 as described above may be located within the peripheral region and located on one side of the pixel array region (as shown in Fig. 1A, between the pixel array region 102 and a side edge of the base substrate), for example, as shown in Fig. 1A, may be located in a peripheral region 102B on a left side of the base substrate, or may also be located in a peripheral region 102B on a right side of the base substrate 1, or may also be located in peripheral regions 102B on both the left side and the right side of the base substrate 1, which will not be limited in the embodiments of the present disclosure.

It should be noted that the above-described trace positions are only exemplary, as long as trace arrangement facilitates connection with the shift register unit, which will not be limited in the embodiments of the present disclosure.

For example, the base substrate 1 may be made of glass, plastic, quartz, or other suitable material, which will not be limited in the embodiments of the present disclosure.

For example, the pixel array region 102 includes a plurality of pixel units 103 arranged in an array. For example, each of the plurality of pixel units 103 includes a pixel circuit, and, for example, may further include a light emitting element (not shown).

For example, the plurality of cascaded shift register units 104 compose a gate driving circuit. For example, the output terminals GOUT of the plurality of shift register units 104 are respectively connected with gate scan signal ends of respective rows of pixel circuits located in the pixel array region to supply output signals (e.g., gate scan signals) to respective row of pixel circuits, thereby driving the light emitting element to emit light. For example, the pixel circuit may be a pixel circuit in the art, including, for example, a circuit structure such as 7T1C, 2T1C, 4T2C, 8T2C, etc., and no details will be repeated here.

Fig. 2 only shows a first-stage shift register unit 104 and a second-stage shift register unit 104 in the gate driving circuit; for example, as shown in Fig. 2, a first clock signal terminal CK (as shown in Fig. 1B) of the first-stage shift register unit 104 is connected with the second sub-clock signal line GCB to receive the first clock signal; a second clock signal terminal CB of the first-stage shift register unit 104 is connected with the first clock signal GCK to receive the second clock signal; a first clock signal terminal CK of the second-stage shift register unit is connected with the first clock signal line GCK to receive the first clock signal, and a second clock signal terminal CB of the second-stage shift register unit is connected with the second sub-clock signal line GCB to receive the second clock signal, and so on, a first clock signal terminal CK of an Xth-stage (X being an odd number greater than 1) shift register unit 104 is connected with the second sub-clock signal line GCB to receive the first clock signal, a second clock signal terminal CB of the Xth-stage shift register unit 104 is connected with the first clock signal GCK to receive the second clock signal; a first clock signal terminal CK of an (X+1)*th*-stage shift register unit is connected with the first clock signal line GCK to receive the first clock signal; and a second clock signal terminal CB of the (X+1)*th*-stage shift register unit is connected with the second sub-clock signal line GCB to receive the second clock signal. It should be noted that the connection modes of the respective stages of shift register units and the clock signal lines may also be other connection modes in the art, which will not be limited in the embodiments of the present disclosure. For example, an input terminal of the first-stage shift register unit 104 is connected with the trigger signal line GSTV to receive the trigger signal as an input signal; an input terminal of the second-stage shift register unit 104 is connected with an output terminal GOUT of a previous stage of shift register unit (i.e., the first-stage shift register unit), and the connection modes of other stages of shift register units are similar thereto. Hereinafter, it will be illustrated by taking the structure of the first-stage shift register unit as an example, which will not be limited in the embodiments of the present disclosure.

For example, in the example shown in Fig. 2, since the first clock end CK (as shown in Fig. 1B) of the first-stage shift register unit 104 is connected with the second sub-clock signal line GCB to receive the first clock signal, and the second clock signal terminal CB of the first-stage shift register unit 104 is connected with the first clock signal GCK to receive the second clock signal, it is illustrated in the example by taking the second sub-clock signal line GCB as the first clock signal line and the first clock signal line GCK as the second clock signal line, which will not be limited in the embodiments of the present disclosure.

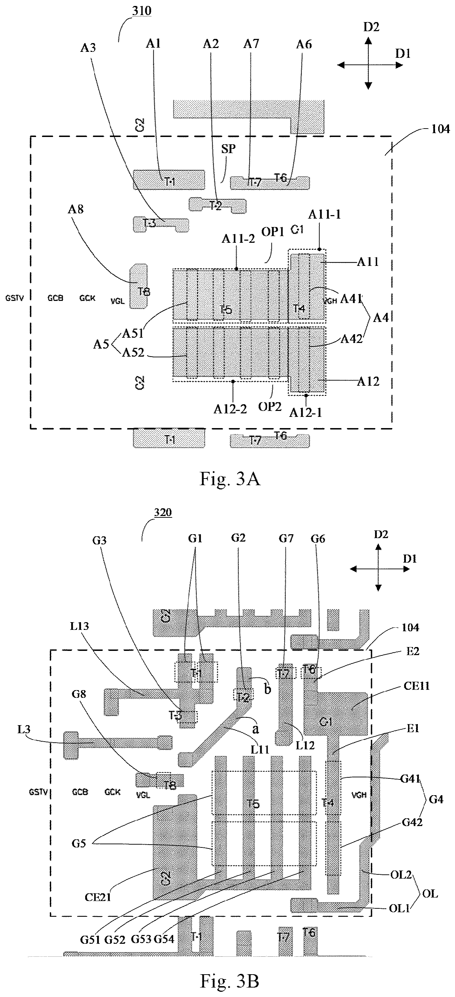

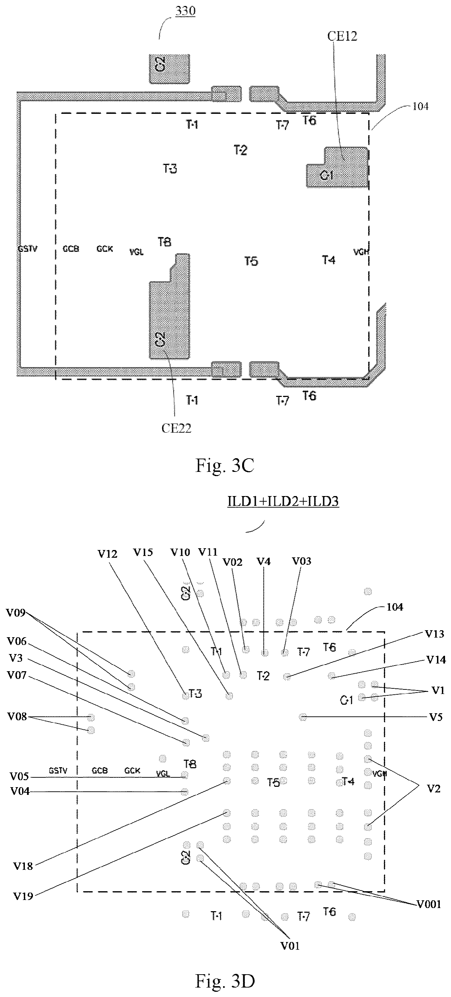

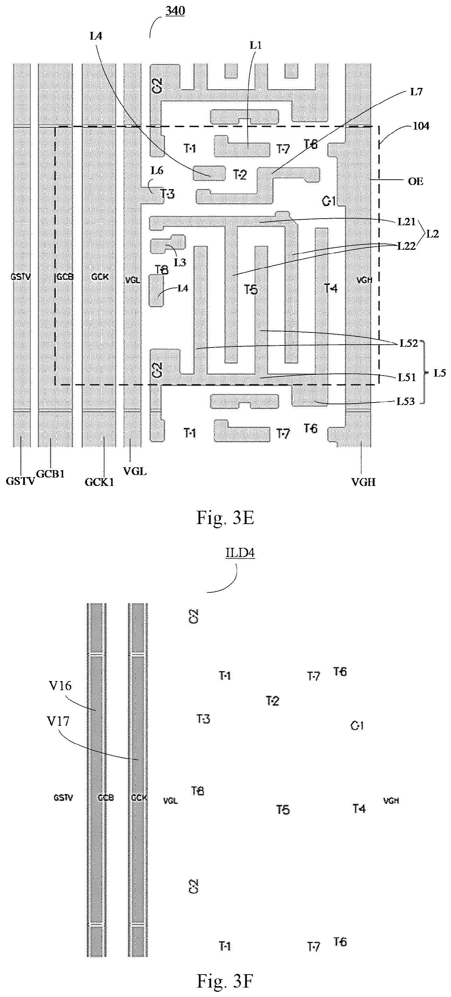

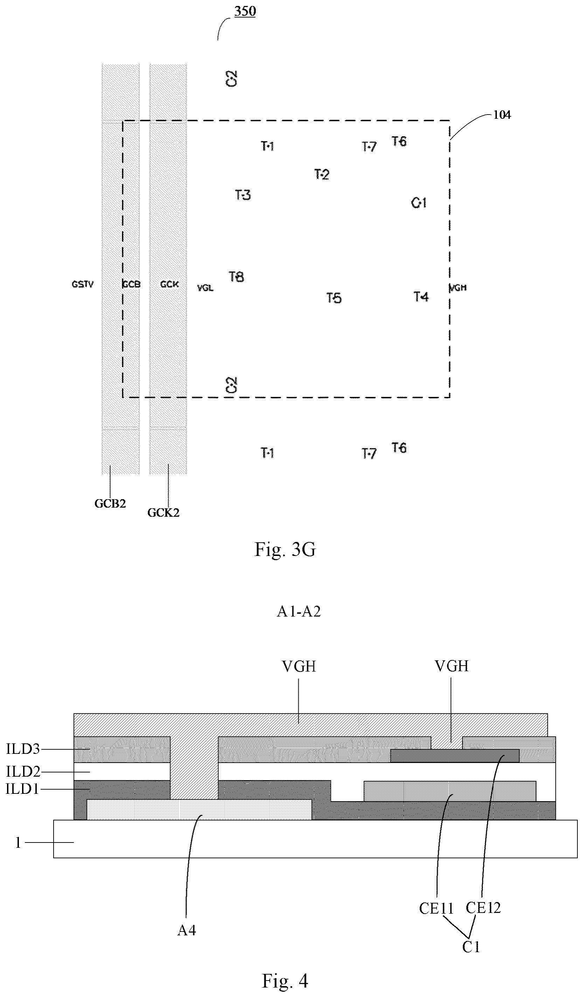

Fig. 3A to Fig. 3G respectively show planar structural schematic diagrams of respective layers of the shift register unit 104 of the display substrate shown in Fig. 2. Fig. 3A is a plan view of a semiconductor layer 310 of the display substrate provided by at least one embodiment of the present disclosure; Fig. 3B is a plan view of a first conductive layer 320 of the display substrate provided by at least one embodiment of the present disclosure; Fig. 3C is a plan view of a second conductive layer 330 of the display substrate provided by at least one embodiment of the present disclosure; Fig. 3D is a schematic diagram of vias in a first insulation layer ILD1, a second insulation layer ILD2, and a third insulation layer ILD3 of the display substrate provided by at least one embodiment of the present disclosure, Fig. 3E is a plan view of a third conductive layer 340 of the display substrate provided by at least one embodiment of the present disclosure; Fig. 3F is a plan view of a via in a fourth insulation layer ILD4 of the display substrate provided by at least one embodiment of the present disclosure; and Fig. 3G is a plan view of a fourth conductive layer 350 of the display substrate provided by at least one embodiment of the present disclosure. Fig. 4 is a cross-sectional schematic diagram along an A1-A2 line in Fig. 2. It should be noted that reference signs T1 to T8, GSTV, GCB, GCK, VGL, VGH, etc. in single-layer diagrams such as Fig. 3D to Fig. 3F only represent that orthographic projections of the structures represented by these reference signs on a main surface of the base substrate 1 are located in positions where corresponding reference signs are located, to facilitate understanding positional relationships between the respective structures in the single-layer diagrams in conjunction with Fig. 2.

For example, on the main surface of the base substrate 1 and in a direction from a position close to the base substrate 1 to a position away from the base substrate 1, the semiconductor layer 310, the first conductive layer 320, the second conductive layer 330, the third conductive layer 340, and the fourth conductive layer 350 are arranged sequentially, that is, the first conductive layer 320 is located on a side of the semiconductor layer 310 that is away from the base substrate 1, the second conductive layer 330 is located on a side of the first conductive layer 320 that is away from base substrate 1, the third conductive layer 340 is located on a side of the second conductive layer 330 that is away from the base substrate 1, and the fourth conductive layer 350 is located on a side of the third conductive layer 340 that is away from the base substrate 1. Of course, a display substrate provided by other embodiments may also include some conductive layers among the first conductive layer 320, the second conductive layer 330, the third conductive layer 340, and the fourth conductive layer 350, and not all the 4 conductive layers must be arranged on a display substrate provided by each embodiment.

For example, an interlayer insulation layer (e.g., including the first insulation layer ILD1, the second insulation layer ILD2, the third insulation layer ILD3, etc. shown in Fig. 4) may be located between the layer structures shown in Fig. 3A to Fig. 3G. For example, the first insulation layer ILD1 (as shown in Fig. 4) is located between the semiconductor layer 310 shown in Fig. 3A and the first conductive layer 320 shown in Fig. 3B; the second insulation layer ILD2 (as shown in Fig. 4) is located between the first conductive layer 320 shown in Fig. 3B and the second conductive layer 330 shown in Fig. 3C; and the third insulation layer ILD3 (as shown in Fig. 4) is located between the second conductive layer 330 shown in Fig. 3C and the third conductive layer 340 shown in Fig. 3E. For example, the third insulation layer ILD3 is a planarization layer, so that the third conductive layer 340 with more wiring is arranged on a flat surface, to facilitate wiring.

For example, referring to Fig. 3A, the active layers A1 to A8 of the respective transistors are located in the semiconductor layer 310; the gate electrodes G1 to G8 of the respective transistors, the first electrode of the first capacitor, and the first electrode of the second capacitor are located in the first conductive layer 320; the second electrode of the first capacitor and the second electrode of the second capacitor are located in the second conductive layer 330; the first power line VGH, the second power line VGL, and the respective connecting electrodes are located in the third conductive layer 340; for example, the first clock signal line GCK and the second clock signal line GCB each include two layers of trace connected with each other in parallel, to reduce total resistance of the two layers of trace. Thus, as shown in Fig. 3E, a first layer of trace GCK1 of the first clock signal line GCK and a first layer of trace GCB1 of the second clock signal line GCB are located in the third conductive layer 340; as shown in Fig. 3G, a second layer of trace GCK2 of the first clock signal line GCK and a second layer of trace GCB2 of the second clock signal line GCB are located in the fourth conductive layer 350; with respect to each of the three, the two layers of trace are electrically connected with each other. Referring to Fig. 3F, the two layers of trace of the first clock signal line GCK are electrically connected with each other through a via V17 running through the fourth insulation layer ILD4, while the two layers of trace of the second clock signal line GCB are electrically connected with each other through a via V16 running through the fourth insulation layer ILD4.

For example, in this embodiment, the trigger signal line GSTV is a single-layer trace. Of course, in other embodiments, the trigger signal line may also be set to a double-layer trace.

For example, materials of the first insulation layer ILD1, the second insulation layer ILD2, and the third insulation layer ILD3 may include inorganic insulation materials such as SiNx, SiOx, SiNxOy, or organic insulation materials such as organic resin, or other suitable materials, which will not be limited in the embodiments of the present disclosure.

It should be noted that the display substrate shown in Fig. 2 is illustrated by taking layout design of the first two stages of shift registers as well as the first power line VGH, the second power line VGL, and signal lines connected therewith in the scan driving circuit as an example; the layout mode shown in Fig. 2 may be referred to for layout implementations of other respective stages of shift registers; and no details will be repeated here. Of course, other layout modes may also be adopted, which will not be limited in the embodiments of the present disclosure. Of course, the layout mode shown in Fig. 2 may be also referred to for the respective shift registers of other respective scan driving circuits, and other layout implementations may also be adopted, which will not be limited in the embodiments of the present disclosure.

Hereinafter, the display substrate provided by at least one embodiment of the present disclosure will be introduced in details in conjunction with Fig. 2 to Fig. 4.

As described above, the shift register unit 104 includes the input circuit 1041, the output circuit 1043, the first control circuit 1042, and the output control circuit 1044; the input circuit 1041 is configured to input the input signal to the first node N1 in response to the first clock signal; the output circuit 1043 is configured to output the output signal to the output terminal GOUT; the first control circuit 1042 is configured to control the level of the second node N2 in response to the level of the first node N1 and the first clock signal; the output control circuit 1044 is configured to control the level of the output terminal GOUT under control of the level of the second node N2; the output control circuit 1044 includes the output control transistor T4; and the output circuit 1043 includes the output transistor T5. The direction parallel to the direction from the non-display region 102B to the display region 102 is defined here as the first direction D1. Referring to Fig. 2 and Fig. 3A, the shift register unit 104 includes the first output semiconductor portion A11 and the second output semiconductor portion A12 that are arranged and spaced apart from each other in the second direction D2, the second direction D2 intersects with the first direction D1, for example, the second direction D2 is perpendicular to the first direction D1. An integral structure composed of the first output semiconductor portion A11 and the second output semiconductor portion A12 includes the active layer A4 of the output control transistor T4 and the active layer A5 of the output transistor T5. Therefore, in the display substrate 10 provided by the embodiment of the present disclosure, the first output semiconductor portion A11 and the second output semiconductor portion A12 of the shift register unit 104 are arranged and spaced apart from each other in the second direction D2 instead of the first direction D1.The active layer A4 of the output control transistor T4 and the active layer A5 of the output transistor T5 are formed by the integral structure composed of the first output semiconductor portion A11 and the second output semiconductor portion A12, thereby the space occupied by the integral structure composed of the first output semiconductor portion A11 and the second output semiconductor portion A12 in the first direction D1 is reduced, which can reduce the size of the shift register unit 104 in the first direction D1, and is favorable for realizing a narrower border, moreover, other respective elements such as transistors, capacitors, etc. of the shift register can be arranged by fully utilizing space in the second direction, which can realize a reasonable layout, and ensure display quality of the display panel while narrowing the border of the display panel.

For example, referring to Fig. 2, if a scope of the entire shift register unit 104 is defined as a region including respective elements such as transistors, capacitors, etc., then a proportion of a size of the integral structure composed of the first output semiconductor portion A11 and the second output semiconductor portion A12 in the first direction D1 to the size of the entire shift register unit 104 in the first direction D1 is greater than 1/2; if the scope of the entire shift register unit 104 is defined as a region including respective elements such as transistors, capacitors, etc., as well as the first clock signal line GCK, the second clock signal line GCB, the first power line VGH, the second power line VGL, and the trigger signal line GSTV, then the proportion of the integral structure composed of the first output semiconductor portion A11 and the second output semiconductor portion A12 in the first direction D1 to the size of the entire shift register unit 104 in the first direction D1 is 1/3 to 2/3.

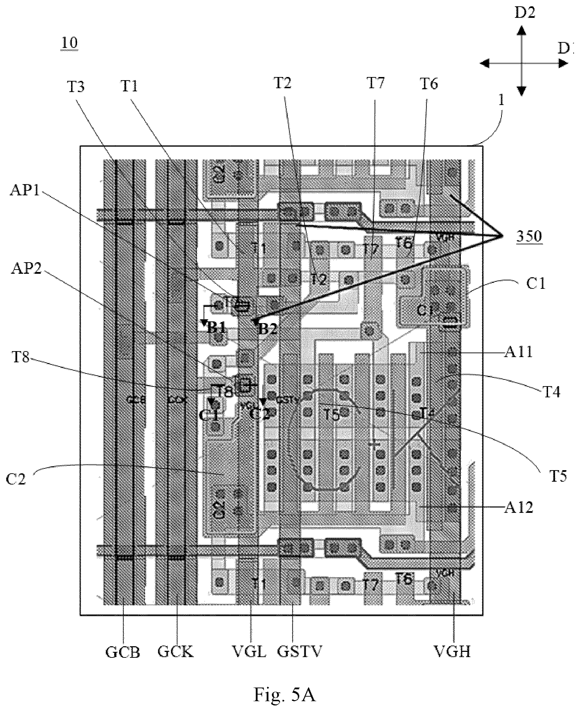

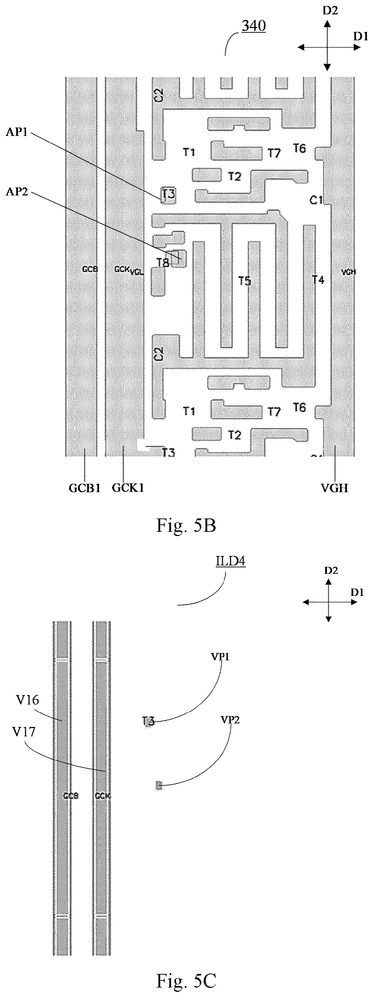

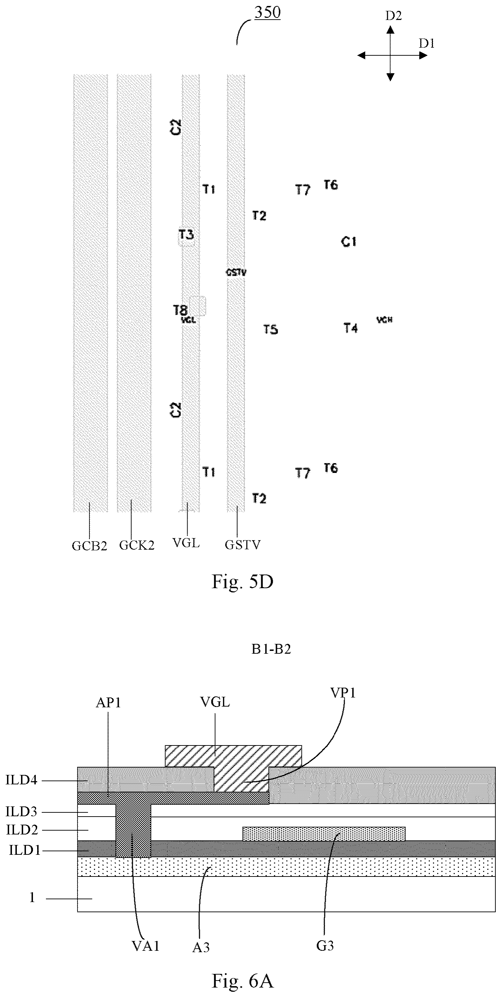

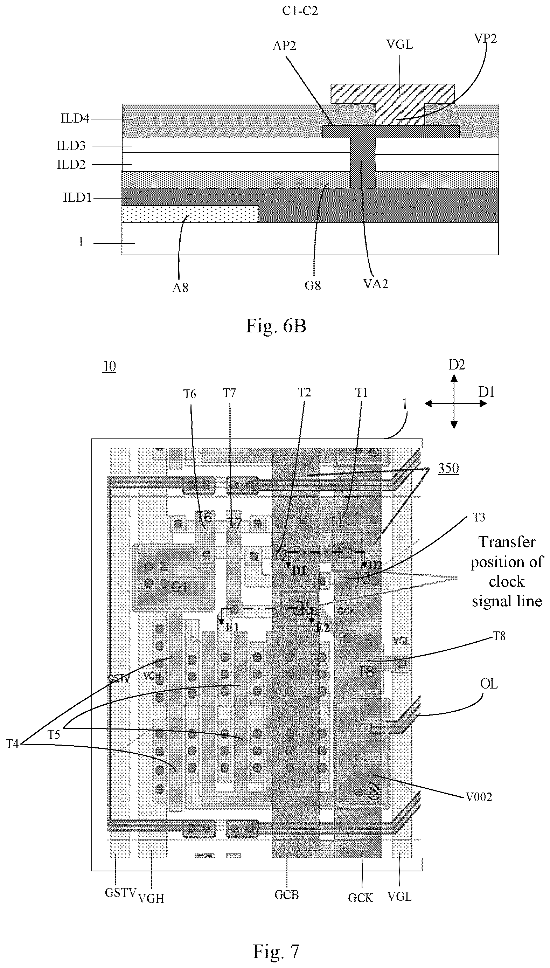

For example, in other embodiments below, if the scope of the entire shift register unit 104 is defined as a region including respective elements such as transistors, capacitors, etc., as well as the first clock signal line GCK, the second clock signal line GCB, the first power line VGH, the second power line VGL, and the trigger signal line GSTV, then the size of the entire shift register unit 104 in the first direction D1 is further reduced because at least one of the first clock signal line GCK, the second clock signal line GCB, the first power line VGH, the second power line VGL, and the trigger signal line GSTV overlaps with the transistor of the shift register unit 104, at this time, the proportion of the size of the integral structure composed of the first output semiconductor portion A11 and the second output semiconductor portion A12 in the first direction D1 to the size of the entire shift register unit 104 in the first direction D1 is improved to varying degrees as compared with the embodiment shown in Fig. 2; for example, in the embodiment shown in Fig. 5A, the proportion is greater than or equal to 1/2, for example, 1/2 to 2/3; for example, in the embodiment shown in Fig. 5A, the proportion is greater than or equal to 1/2, for example, 1/2 to 2/3; for example, in the embodiment shown in Fig. 7, the proportion is greater than 1/2, for example greater than 2/3. The greater of the size of the integral structure composed of the first output semiconductor portion A11 and the second output semiconductor portion A12 in the first direction D1 the integral structure composed of the first output semiconductor portion A11 and the second output semiconductor portion A12 in the first direction D1 in the size of the entire shift register unit 104 in the first direction D1, the more significant the effect of the arrangement of the first output semiconductor portion A11 and the second output semiconductor portion A12 being spaced apart from each other in the second direction D2 on the size of the narrowed border in the first direction.

A height of a shift register unit refers to a height of a shift register unit in the second direction D2; and a length of a shift register unit refers to a length of a shift register unit in the first direction D1. For example, referring to Fig. 2, a length/height ratio of a shift register unit is approximately 1.2:1; for example, a shift register unit has a height of 100.8 µm in the second direction D2, has and a length of 127 µm in the first direction D1. With respect to a conventional shift register unit, the first output semiconductor portion A11 and the second output semiconductor portion A12 are arranged in the first direction D1, the conventional shift register unit has a height of 65 µm in the second direction D2, a length of 180 µm in the first direction D1, and a length/height ratio of approximately 3:1. Thus, it can be seen that the conventional shift register unit occupies 180 µm of the border in the first direction D1, space occupied thereby is relatively large, which is suitable for a large-sized display substrate, for example, suitable for a display substrate whose pixel size is greater than or equal to 65 µm; here, the "pixel size" refers to a height of a row of pixels driven by the shift register unit in the display region in the second direction D2; the larger the pixel size, the lower the vertical space utilization rate of the conventional shift register unit; however, the above-described length/height ratio of the shift register unit of the display substrate provided by the embodiment of the present disclosure is greatly reduced as compared with the conventional shift register unit, which is not only applicable to a display substrates with a smaller pixel size, but also applicable to a display substrate with a larger pixel size, for example, applicable to driving pixels whose single-row pixel size is larger than or equal to 100 µm, or driving two rows of pixels with a pixel size of each row larger than or equal to 50 µm. Moreover, with respect to a small-sized display substrate, the conventional shift register unit may cause a border size to be too large, which greatly affects a narrow border display effect of the small-sized display substrate; however, the shift register unit of the display substrate provided by the embodiment of the present disclosure may significantly narrow the border, and may also achieve a good narrow border display effect for a small-sized display substrate.

For example, a width of the trigger signal line GSTV in the first direction D1 is 4 µm to 8 µm; a width of the first power line VGH in the first direction D1 is 5 µm to 20µm; a width of the second power line VGL in the first direction D1 is 5 µm to 20 µm; a width of each clock signal line in the first direction D1 is 5 µm to 25 µm; a distance between the respective signal lines is, for example, 2 µm to 10 µm, such that the fabrication process may be implemented and impact of signal crosstalk may be avoided. Thus, sufficient space may still be ensured to arrange signal lines having various functions side by side and make the signal line overlap with the transistor or the capacitor in the direction perpendicular to the main surface of the base substrate 1, while optimizing the arrangement mode of the respective transistors and capacitors to the extreme.

For example, as described above, the input circuit 1041 includes the input transistor T1; and the first control circuit 1042 includes the first control transistor T2 and the second control transistor T3. Referring to Fig. 2 and Fig. 3A, the active layer A1 of the input transistor T1, the active layer A2 of the first control transistor T2, and the active layer A3 of the second control transistor T3 are all located on a first side of the integral structure composed of the first output semiconductor portion A11 and the second output semiconductor portion A12 in the second direction D2. In this way, the active layer A1 of the input transistor T1, the active layer A2 of the first control transistor T2, and the active layer A3 of the second control transistor T3, as well as the integral structure composed of the first output semiconductor portion A11 and the second output semiconductor portion A12, are arranged in the second direction D2, which fully utilizes the space of the border region in the second direction D2, avoids the active layers of these transistors from being arranged in the first direction D1 and occupying too much space in the first direction D1, further reduces the size of the shift register unit 104 in the first direction D1, and is favorable for implementing a narrower border. Meanwhile, since connections of the input transistor T1, the first control transistor T2, and the second control transistor T3 with other transistors and signal lines are implemented without crossing the first output semiconductor portion A11 and the second output semiconductor portion A12, such arrangement may also facilitate utilizing the space on one side of the integral structure composed of the first output semiconductor portion A11 and the second output semiconductor portion A12 in the second direction D2 to arrange signal lines so as to electrically connect the input transistor T1, the first control transistor T2, and the second control transistor T3 with other transistors and signal lines, thereby reasonably arranging more transistors, capacitors, and signal lines, ensuring display quality of the display panel while reducing the border of the display panel.

For example, in the shift register unit 104, the second control circuit 1045 is connected with the first node N1 and the second node N2; and the second control circuit 1045 is configured to control the level of the first node N1 under control of the level of the second node N2 and the second clock signal. For example, as described above, the second control circuit 1045 includes a first denoising transistor T6 and a second denoising transistor T7. Referring to Fig. 2 and Fig. 3A, the active layer A6 of the first denoising transistor T6 and the active layer A7 of the second denoising transistor T7 are both located on the first side of the integral structure composed of the first output semiconductor portion A11 and the second output semiconductor portion A12 in the second direction D2. In this way, the active layer A6 of the first denoising transistor T6 and the active layer A7 of the second denoising transistor T7, as well as the integral structure composed of the first output semiconductor portion A11 and the second output semiconductor portion A12 are arranged in the second direction D2, which fully utilizes the space of the border region in the second direction D2, and avoids the active layer A6 of the first denoising transistor T6 and the active layer A7 of the second denoising transistor T7 from being arranged in the first direction D1 and occupying too much space in the first direction D1, further reduces the size of the shift register unit 104 in the first direction D1, and is favorable for implementing a narrower border. Meanwhile, since connection of the first denoising transistor T6 and the second denoising transistor T7 with other transistors and signal lines is implemented without crossing the first output semiconductor portion A11 and the second output semiconductor portion A12, such arrangement of the active layer A6 of the first denoising transistor T6 and the active layer A7 of the second denoising transistor T7 may also facilitate utilizing the space on one side of the integral structure composed of the first output semiconductor portion A11 and the second output semiconductor portion A12 in the second direction D2 to arrange signal lines to electrically connect the first denoising transistor T6 and the second denoising transistor T7 with other transistors and signal lines, thereby reasonably arranging more transistors, capacitors, and signal lines, ensuring display quality of the display panel while reducing the border of the display panel.

Referring to Fig. 2 and Fig. 3B, an electrode in which the gate electrode G4 of the output control transistor T4 is located includes a strip structure extending along the second direction D2; each strip structure includes two strip portions G41/G42 respectively overlapping with the first output semiconductor portion A11 and the second output semiconductor portion A12. Thus, the two strip portions A41/A42 respectively extend along the second direction D2; and the two strip portions G41/G42 compose the gate electrode G4 of the output control transistor T4. Here, it is illustrated by taking that the electrode in which the gate electrode G4 of the output control transistor T4 is located has one strip structure, and the one strip structure includes two strip portions G41/G42 as an example. The number of strip structures is not limited to one. An electrode in which the gate electrode G5 of the output transistor T5 is located includes a plurality of strip structures G51/G52/G53/G54 spaced apart in the first direction D1; each strip structure G51/G52/G53/G54 extends along the second direction D2; and each strip structure G51/G52/G53/G54 includes two strip portions G501/G502 respectively overlapping with the first output semiconductor portion A11 and the second output semiconductor portion A12, so, the two strip portions G501/G502 respectively extend along the second direction D2, and the strip portions of the plurality of strip structures G51/G52/G53/G54 compose the gate electrode G5 of the output transistor T5.

It should be noted that an active layer of a certain transistor according to the present disclosure refers to a channel region of the transistor, that is, a portion in which a semiconductor layer of the transistor overlaps with a gate electrode of the transistor in the direction perpendicular to the main surface of the base substrate. The active layer A4 of the output control transistor T4 refers to a channel region of the output control transistor T4, that is, a portion in which the first output semiconductor portion A11 and the second output semiconductor portion A12 overlap with the gate electrode G4 of the output control transistor T4, that is, a portion thereof overlapping with the two strip portions G41/G42; the active layer A5 of the output transistor T5 refers to a channel region of the output transistor T5, that is, a portion in which the first output semiconductor portion A11 and the second output semiconductor portion A12 overlap with the gate electrode G5 of the output transistor T5, that is, a portion thereof overlapping with a plurality of strip structures G51/G52/G53/G54 of the gate electrode G5 of the output transistor T5.

For example, referring to Fig. 2 and Fig. 3A, the active layer A4 of the output control transistor T4 and the active layer A5 of the output transistor T5 respectively include a plurality of sub-channel regions. The plurality of sub-channel regions of the output control transistor T4 include at least one first sub-channel region A41 and at least one second sub-channel region A42; and the plurality of sub-channel regions of the output transistor T5 include at least one first sub-channel region A51 and at least one second sub-channel region A52. At least one first sub-channel region A41 of the output control transistor T4 and at least one first sub-channel region A51 of the output transistor T5 are both located in the first output semiconductor portion A11 and are arranged in the first direction D1; at least one first sub-channel region A41 is a portion in which the first output semiconductor portion A11 overlaps with the gate electrode of the output control transistor T4; and at least one first sub-channel region A51 is a portion in which the first output semiconductor portion A11 overlaps with the gate electrode of the output transistor T5. At least one second sub-channel region A42 of the output control transistor T4 and at least one second sub-channel region A52 of the output transistor T5 are located in the second output semiconductor portion A12 and are arranged in the first direction D1; at least one second sub-channel region A42 is a portion in which the second output semiconductor portion A12 overlaps with the gate electrode of the output control transistor T4; and at least one second sub-channel region A52 is a portion in which the second output semiconductor portion A12 overlaps with the gate electrode of the output transistor T5.

Therefore, corresponding to shapes of orthographic projections of the gate electrode of the output control transistor T4 and the gate electrode of the output transistor T5 on the base substrate 1, orthographic projections of each first sub-channel region A4 and each second sub-channel region A42 of the output control transistor T4 on the base substrate 1 each has a strip shape extending along the second direction D2, and orthographic projections of each first sub-channel region A51 and each second sub-channel region A52 of the output transistor T5 on the base substrate 1 each has a strip shape extending along the second direction D2, so that lengths of each first sub-channel region A4 and each second sub-channel region A42 of the output control transistor T4 in the second direction D2 are respectively much greater than respective lengths thereof in the first direction D1, and lengths of each first sub-channel region A51 and each second sub-channel region A52 of the output transistor T5 in the second direction D2 are respectively much greater than respective lengths thereof in the first direction D1, which is favorable for increasing the width/length ratio of the output control transistor T4 and the width/length ratio of the output transistor T5 respectively, to reduce a heating degree of the output control transistor T4 and the output transistor T5, thereby extending a lifespan of the output control transistor T4 and the output transistor T5, and improving display quality of the display panel.

For example, referring to Fig. 3A, lengths of each first sub-channel region A41 and each second sub-channel region A42 in the second direction D2 are both greater than twice or three times the respective lengths thereof in the first direction D1; for example, lengths of each first sub-channel region A51 and each second sub-channel region A52 in the second direction D2 are both greater than twice or three times the respective lengths thereof in the first direction D1. As described below, referring to Fig. 2 and Fig. 3E, in a case where the first power line VGH serves as the first electrode of the output control transistor T4, and a strip-shaped extending portion L52 is electrically connected with the output signal line OL to serve as the second electrode of the output control transistor T4 and the second electrode of the output transistor T5, a channel width W of the output control transistor T4 is a sum of lengths of all sub-channel regions A41 and A42 of the output control transistor T4 in the second direction D2, a channel length L of the output control transistor T4 is an average length of all sub-channel regions A41 and A42 of the output control transistor T4 in the first direction D1, a channel width W of the output transistor T5 is a sum of lengths of all sub-channel regions A51 and A52 of the output transistor T5 in the second direction D2, and a channel length L of the output transistor T5 is an average length of all sub-channel regions A51 and A52 of the output transistor T5 in the first direction D1, which respectively increases the channel width (W) of the output control transistor T4, and thus utilizes the space in the second direction D2 to increase the width/length ratios (W/L) of the output control transistor T4 and the output transistor T5.

For example, referring to Fig. 3A, a length of the first output semiconductor portion A11 in the first direction D1 is greater than a length of the first output semiconductor portion A11 in the second direction D2; and a length of the second output semiconductor portion A12 in the first direction D1 is greater than a length of the second output semiconductor portion A12 in the second direction D2. Since the above-described plurality of transistors, as well as the integral structure composed of the output control transistor T4 and the output transistor T5 in the second direction D2 are arranged in the second direction D2, sufficient space is reserved for arranging the output control transistor T4 and the output transistor T5 in the first direction D1, allowing the length of the first output semiconductor portion A11 in the first direction D1 and the length of the second output semiconductor portion A12 in the first direction D1 to be greater, which is favorable for improving the width/length ratios of the output control transistor T4 and the output transistor T5, reducing a heating degree of the output control transistor T4 and the output transistor T5, prolonging the lifespan of the output control transistor T4 and the output transistor T5, and improving display quality of the display panel.

For example, referring to Fig. 2 and Fig. 3A, the first output semiconductor portion A11 includes a first portion A11-1 and a second portion A11-2 arranged in the first direction D1 and connected with each other, and the second output semiconductor portion A12 includes a first portion A12-1 and a second portion A12-2 arranged in the first direction D1 and connected with each other; the first portion A11-1 of the first output semiconductor portion A11 and the first portion A12-1 of the second output semiconductor portion A12 both overlap with the gate electrode G4 of the output control transistor T4; for example, an entire length range of the first portion A11-1 of the first output semiconductor portion A11 in the second direction D2 overlaps with the gate electrode G4 of the output control transistor T4, and an entire length range of the first portion A12-1 of the second output semiconductor portion A12 in the second direction D2 overlaps with the gate electrode G4 of the output control transistor T4; the second portion A11-2 of the first output semiconductor portion A11 and the second portion A12-2 of the second output semiconductor portion A12 both overlap with the gate electrode G5 of the output transistor T5; moreover, a length of the first portion A11-1 of the first output semiconductor portion A11 in the second direction D2 is greater than a length of the second portion A11-2 of the first output semiconductor portion A11 in the second direction D2, and a length of the first portion A12-1 of the second output semiconductor portion A12 in the second direction D2 is greater than a length of the second portion A12-2 of the second output semiconductor portion A12 in the second direction D2. In this way, the length of the channel region of the output control transistor T4 may be made longer, and the width/length ratio of the output control transistor T4 may be increased. Since an operation heating problem of the output control transistor T4 is usually serious in the shift register unit, it is particularly necessary to increase the width/length ratio to alleviate the heating problem of the output control transistor T4 and extend an operation life thereof.

For example, in Fig. 3A, an edge of the first output semiconductor portion A11 that is away from the second output semiconductor portion A12 has a first recess notch OP1, and an edge of the second output semiconductor portion A12 that is away from the first output semiconductor portion A11 has a second recess notch OP2, so that the length of the first portion A11-1 of the first output semiconductor portion A11 in the second direction D2 is greater than the length of the second portion A11-2 of the first output semiconductor portion A11 in the second direction D2; in additional, connection between respective elements such as transistors of the shift register unit 104 may be implemented by utilizing the space of the first recess notch OP1 and the second recess notch OP2 to arrange connecting electrodes, which can ensure display quality while narrowing the border by reducing space occupied by the shift register unit 104 as a whole.

For example, referring to Fig. 1B, Fig. 2 and Fig. 3B, the output control circuit 1044 further includes a first capacitor C1; the first electrode CE11 of the first capacitor C1 is electrically connected with the second node N2; the display substrate 10 further includes a first power line VGH; the first power line VGH is configured to supply a first voltage to the shift register unit 104; and the second electrode CE12 of the first capacitor C1 is electrically connected with the first power line VGH. For example, the first capacitor C1 is located on the first side of the integral structure composed of the first output semiconductor portion A11 and the second output semiconductor portion A12 in the second direction D2. Thus, the size of the shift register unit 104 in the first direction D1 is further reduced, which is favorable for narrowing the border.

For example, the first capacitor C1, as well as the input transistor T1, the first control transistor T2, the second control transistor T3, the first denoising transistor T6, and the second denoising transistor T7, are all located on a same side of the integral structure composed of the first output semiconductor portion A11 and the second output semiconductor portion A12 in the second direction D2, so that the first capacitor C1 is closer to the first denoising transistor T6 to facilitate electrical connection between the first electrode CE11 of the first capacitor C1 and the gate electrode G6 of the first denoising transistor T6, which may utilize limited space to implement reasonable layout of the electrical circuit structure while reducing the width of the border, so as to meet requirements of the circuit structure, shorten connection lines between the respective components as much as possible, and ensure display quality of the display substrate 10.

For example, referring to Fig. 2 and Fig. 3A to Fig. 3B, the first capacitor C1 is located between the active layer A6 of the first denoising transistor T6 and the integral structure composed of the first output semiconductor portion A11 and the second output semiconductor portion A12, to facilitate electrical connection between the first electrode CE11 of the first capacitor C1 and the gate electrode G6 of the first denoising transistor T6, which may utilize limited space to implement reasonable layout of the electrical circuit structure while reducing the width of the border. For example, the first electrode CE11 of the first capacitor C1 is electrically connected with the gate electrode G6 of the first denoising transistor T6 and the gate electrode G4 of the output control transistor T4, composing a continuous integral structure, to simplify the structure of the display substrate 10, and facilitate utilizing limited border space to arrange a plurality of elements such as transistors and capacitors, etc. Moreover, the integral structure may be formed by using a same patterning process, which reduces a difficulty in fabricating the display substrate 10.

For example, referring to Fig. 2 and Fig. 3B, an electrode E1 in which the gate electrode G4 of the output control transistor T4 is located extends from the first electrode CE11 of the first capacitor C1 along the second direction D2 towards the integral structure composed of the first output semiconductor portion A11 and the second output semiconductor portion A12; an orthographic projection of the gate electrode G4 of the output control transistor T4 on the base substrate 1 at least partially overlaps with an orthographic projection of the first output semiconductor portion A11 on the base substrate 1, and at least partially overlaps with an orthographic projection of the second output semiconductor portion A12 on the base substrate 1; an electrode E2 in which the gate electrode G6 of the first denoising transistor T6 is located extends from the first electrode CE11 of the first capacitor C1 along the second direction D2 towards the active layer A6 of the first denoising transistor T6, and an orthographic projection thereof on the base substrate 1 at least partially overlaps with an orthographic projection of the active layer A6 of the first denoising transistor T6 on the base substrate 1.

For example, referring to Fig. 2 and Fig. 3E, the first power line VGH extends along the second direction D2 as a whole; the first power line VGH is located on a first side of an integral structure composed of the active layer A1 of the input transistor T1, the active layer A2 of the first control transistor T2, the second control transistor T3 and the active layer A7 of the second denoising transistor T7 in the first direction D1; and the first side is a side close to the display region 102, so that the first power line VGH passes through a position corresponding to the first capacitor C1, to facilitate the first power line VGH to pass through the position to be electrically connected with the second electrode CE12 of the first capacitor C1.

For example, referring to Fig. 2 and Fig. 4, an orthographic projection of the first power line VGH on the base substrate 1 overlaps with an orthographic projection of the second electrode CE12 of the first capacitor C1 on the base substrate; and the first power line VGH is electrically connected with the second electrode CE12 of the first capacitor C1 through a first via V1; for example, the first power line VGH is electrically connected with the second electrode CE12 of the first capacitor C1 through a plurality of first vias V1. For example, the first power line VGH and the first electrode of the output control transistor T4 compose a continuous integral structure; the orthographic projection of the first power line VGH on the base substrate 1 overlaps with both the orthographic projection of the first output semiconductor portion A11 on the base substrate 1 and the orthographic projection of the second output semiconductor portion A12 on the base substrate 1; moreover, the first power line VGH is electrically connected with the first output semiconductor portion A11 and the second output semiconductor portion A12 through a second via V2, so the first power line VGH may serve as the first electrode of the output control transistor T4, and reasonably utilizes the smaller border region to layout the first power line VGH, the output control transistor T4, the first capacitor C1, and the first denoising transistor T6 having connection relationships.

For example, referring to Fig. 2 and Fig. 3E, the first power line VGH has an outer edge OE away from the input transistor T1 in the first direction D1 and extending along the second direction D2; the first power line VGH covers an edge of the first output semiconductor portion A11 that extends along the second direction D2 and an edge of the second output semiconductor portion A12 that extends along the second direction D2; and the outer edge OE of the first power line VGH is located on a side of the integral structure composed of the first output semiconductor portion A11 and the second output semiconductor portion A12 that is away from the input transistor T1 in the first direction D1, that is, the first power line VGH covers the edge of the first output semiconductor portion A11 that extends along the second direction D2 and exceeds the edge, and covers the edge of the second output semiconductor portion A12 that extends along the second direction D2 and exceeds the edge.

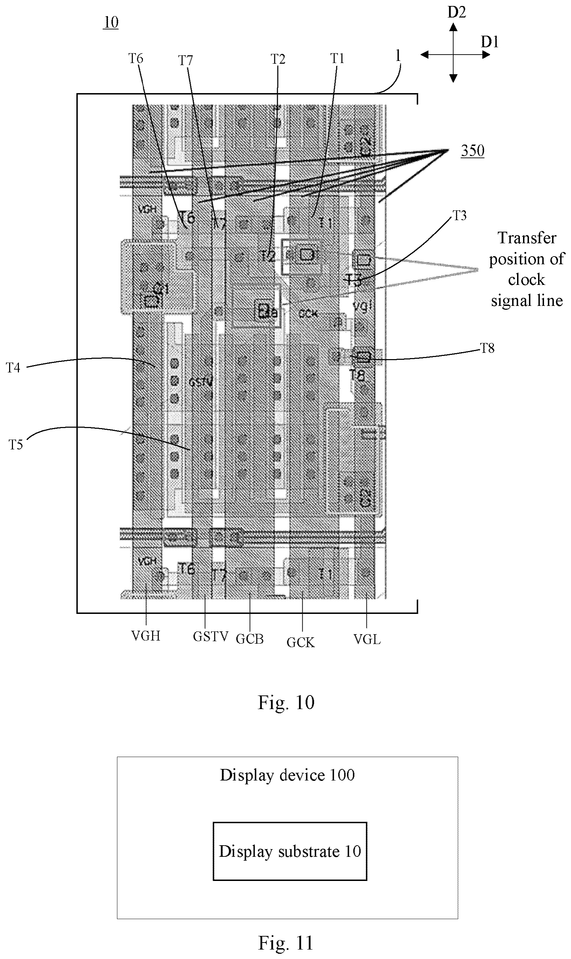

Or, in other embodiments, for example, in an embodiment shown in Fig. 10 below, the outer edge of the first power line VGH aligns with the edge of the first output semiconductor portion A11 that extends along the second direction D2, and aligns with the edge of the second output semiconductor portion A12 that extends along the second direction D2, to avoid the first power line VGH from occupying additional space in the first direction D1, so as to further reduce the border size of the display substrate.

For example, as described above, referring to Fig. 1B, the output circuit 1043 further includes the second capacitor C2; a first electrode CE21 of the second capacitor C2 is connected with a control terminal of the output circuit 1043; and a second electrode of the second capacitor C2 is connected with the output terminal GOUT. For example, referring to Fig. 2, the second capacitor C2 is located on a side of the integral structure composed of the first output semiconductor portion A11 and the second output semiconductor portion A12 in the first direction D1. For example, in the embodiment shown in Fig. 2, the second capacitor C2 is located on a side of the integral structure composed of the first output semiconductor portion A11 and the second output semiconductor portion A12 that is away from the display region 102 in the first direction D1. Since the second capacitor C2 needs to be electrically connected with the output control transistor T4 and the output transistor T5, in a case where the side in the second direction has been used to arrange the input transistor T1, the first control transistor T2, the second control transistor T3, the first denoising transistor T6, and the second denoising transistor T7, such arrangement of the position of the second capacitor C2 may allow the second capacitor C2 to be close to the output control transistor T4 and the output transistor T5, which facilitates the second capacitor C2 to be electrically connected with the output control transistor T4 and the output transistor T5, so as to save space and reduce the border width of the display substrate 10.

For example, the second capacitor C2 is adjacent to the integral structure composed of the first output semiconductor portion A11 and the second output semiconductor portion A12 in the first direction D1, for example, the second capacitor C2 is adjacent to the output transistor T5, to make the structure in the first direction D1 compact, which is favorable for reducing the border width of the display substrate 10. The term "adjacent" here refers to that no other electronic element (e.g., transistor, capacitor, etc.) is present between the adjacent two.

For example, a length of the second capacitor C2 in the second direction D2 is greater than a length of the second capacitor C2 in the first direction D1, so as to fully utilize space in the second direction to increase an area of a capacitor plate of the second capacitor C2, ensure display effect, and avoid the second capacitor C2 from occupying too much space in the first direction D1, which is favorable for reducing the border width of the display substrate 10.

For example, referring to Fig. 2 and Fig. 3A to Fig. 3B, an orthographic projection of the active layer A3 of the second control transistor T3 on a plane parallel to the first direction D1 at least partially overlaps with an orthographic projection of the active layer A1 of the input transistor T1 on the plane parallel to the first direction D1, and at least partially overlaps with an orthographic projection of the second capacitor C2 on the plane parallel to the first direction D1, that is, the active layer A3 of the second control transistor T3 and the active layer A1 of the input transistor T1 have an overlapping portion in the second direction D1, in other words, the active layer A3 of the second control transistor T3 and the active layer A1 of the input transistor T1 have portions right facing each other in the second direction D1, the active layer A3 of the second control transistor T3 and the second capacitor C2 have an overlapping portion in the second direction D1, or in other words, the active layer A3 of the second control transistor T3 and the active layer A1 of the input transistor T1 have portions facing each other in the second direction D1, to reduce the width of the shift register unit in the first direction D1, which is favorable for reducing the border width of the display substrate 10.

For example, referring to Fig. 3A, the active layer A1 of the input transistor T1, the active layer A6 of the first denoising transistor T6, and the active layer A7 of the second denoising transistor T7 are arranged in the first direction D1; and the active layer A1 of the input transistor T1, the active layer A2 of the first control transistor T2, and the active layer A3 of the second control transistor T3 are arranged in the second direction D2, to reasonably utilize space on the first side of the integral structure composed of the first output semiconductor portion A11 and the second output semiconductor portion A12 in the second direction for layout, thereby avoiding excessive space occupation in the first direction, and facilitating connection between interrelated transistors. For example, the active layer A6 of the first denoising transistor T6 and the active layer A7 of the second denoising transistor T7 are a continuous integral structure, to simplify the structure and the fabrication process of the display substrate.

For example, an integral structure composed of the active layer A1 of the input transistor T1, the active layer A6 of the first denoising transistor T6, and each selected from a group consisting of the active layer A7 of the second denoising transistor T7, the active layer A2 of the first control transistor T2, and the active layer A3 of the second control transistor T3 is in a strip shape extending along the first direction D1 as a whole. For example, the integral structure composed of the active layer A1 of the input transistor T1, the active layer A6 of the first denoising transistor T6, and the active layer A7 of the second denoising transistor T7 is arranged substantially along a same straight line in the first direction D1. In this way, the active layers of the plurality of transistors are arranged neatly and easy to fabricate, so that a fabrication yield of the display substrate is improved, and the entire shift register unit 104 is compact in structure, which is favorable for reducing the border size of the display substrate.

For example, referring to Fig. 3A, in the first direction D1, there is a space SP between the active layer A1 of the input transistor T1 and the active layer A7 of the second denoising transistor T7; the active layer A2 of the first control transistor T2 at least partially overlaps with the space SP in the second direction D2, to facilitate utilizing the space to arrange a connecting electrode, so as to implement connections between the input transistor T1, the first control transistor T2, the first denoising transistor T6, and the second denoising transistor T7.

For example, referring to Fig. 2 and Fig. 3E, the first electrode of the input transistor T1 and the first electrode of the second denoising transistor T7 are both connected with the first node N1; the first electrode of the input transistor T1 and the first electrode of the second denoising transistor T7 compose a continuous integral first connection electrode L1; the first connection electrode L1 is at least partially located in the space SP; and an electrode L11 (i.e., a first auxiliary connecting electrode L11) in which the gate electrode G2 of the first control transistor T2 is located extends through the space SP to be electrically connected with the first connection electrode L1. For example, referring to Fig. 2 and Fig. 3D, a first end of the first auxiliary connecting electrode L11 is electrically connected with the first connection electrode L1 through a via V4.

For example, referring to Fig. 2, Fig. 3A and Fig. 3E, each selected from a group consisting of the active layer A1 of the input transistor T1, the active layer A7 of the second denoising transistor T7 and the first connection electrode L1 is in a strip shape extending along the first direction D1 as a whole; two ends of the first connection electrode L1 in the first direction D1 are respectively electrically connected with an end of the active layer A1 of the input transistor T1 and an end of the active layer A7 of the second denoising transistor T7 that are opposite to each other in the first direction D1. For example, referring to Fig. 2 and Fig. 3D, a first end of the first connection electrode L1 in the first direction D1 is electrically connected with the active layer A1 of the input transistor T1 through a via V02, and a second end of the first connection electrode L1 in the first direction D1 is electrically connected with the active layer A7 of the second denoising transistor T7 through a via V03.

For example, as described above, referring to Fig. 1B, the shift register unit 104 further includes a voltage stabilizing circuit 1046; the voltage stabilizing circuit 1046 is connected with the first node N1 and the third node N3, and is configured to stabilize the level of the third node N3; the control terminal of the output circuit 1043 is connected with the third node N3; the output circuit 1043 is configured to output the output signal to the output terminal GOUT under control of the level of the third node N3; and the voltage stabilizing circuit 1046 includes a voltage stabilizing transistor T8. Referring to Fig. 2 and Fig. 3A, the active layer A8 of the voltage stabilizing transistor T8 and the second capacitor C2 are both located on the first side of the integral structure composed of the first output semiconductor portion A11 and the second output semiconductor portion A12 in the first direction D1, for example, a side away from the display region, or, of course, a side close to the display region in other embodiments, which may be changed according to actual needs. In addition, for example, orthographic projections of the active layer A8 of the voltage stabilizing transistor T8 and the second capacitor C2 on a plane parallel to the second direction D2 both at least partially overlaps with an orthographic projection of the integral structure composed of the first output semiconductor portion A11 and the second output semiconductor portion A12 on the plane parallel to the second direction D2; that is, both the active layer A8 of the voltage stabilizing transistor T8 and the second capacitor C2 have portions overlapping with or say have portions facing the integral structure composed of the first output semiconductor portion A11 and the second output semiconductor portion A12, to fully utilize limited space and avoid the shift register unit from occupying too much space.

For example, the active layer A8 of the voltage stabilizing transistor T8 is located on a side of the second capacitor C2 that is close to the input transistor T1 in the second direction D2, that is to say, the active layer A8 of the voltage stabilizing transistor T8 is located between the second capacitor C2 and the input transistor T1, so that the voltage stabilizing transistor T8 may be electrically connected with the second capacitor C2 and the input transistor T1 respectively, to reduce lengths of the connection lines and difficulties in wiring, and reasonably utilize space for layout. In addition, for example, an orthographic projection of the active layer A8 of the voltage stabilizing transistor T8 on a plane parallel to the first direction D1 at least partially overlaps with an orthographic projection of the second capacitor C2 on the plane parallel to the first direction D1, that is, the active layer A8 of the voltage stabilizing transistor T8 and the second capacitor C2 have an overlapping portion, or say, have portions facing each other in the second direction, to reduce space occupied by the second capacitor C2 and the voltage stabilizing transistor T8 in the first direction D1, which is favorable for reducing the border width of the display substrate 10.

For example, the voltage stabilizing transistor T8 is located on a side of the first control transistor T2 that is close to the second capacitor C2 in the second direction D2; and the first electrode of the voltage stabilizing transistor T8 is electrically connected with the first electrode CE21 of the second capacitor C2. An orthographic projection of the voltage stabilizing transistor T8 on a plane parallel to the first direction D1 does not overlap with an orthographic projection of the first control transistor T2 on the plane parallel to the first direction D1, and overlaps with an orthographic projection of the second control transistor T3 on the plane parallel to the first direction D1, to facilitate an electrical connection between the voltage stabilizing transistor T8 and the second capacitor C2, and stagger the voltage stabilizing transistor T8 from the first control transistor T2, which ensures that the first control transistor T2 may be electrically connected with the input transistor T1, the second denoising transistor T7, and the voltage stabilizing transistor T8 at a same time while narrowing the border, and also reduces space occupied by the voltage stabilizing transistor T8 and the second control transistor T3 in the first direction D1.

Referring to Fig. 2 and Fig. 3, the shift register unit 104 further includes a third connection electrode L3 and a fourth connection electrode L4; for example, the first electrode of the voltage stabilizing transistor T8 is electrically connected with the first electrode CE21 of the second capacitor C2 through the fourth connection electrode L4. Referring to Fig. 2 and Fig. 3D, a first end of the fourth connection electrode L4 is electrically connected with the first electrode CE21 of the second capacitor C2 through a via 04, and a second end of the fourth connection electrode L4 is electrically connected with the first electrode of the voltage stabilizing transistor T8 through a via 05. For example, a first end of the first auxiliary connecting electrode L11 is electrically connected with the first connection electrode L1 through a via V4, a second end of the first auxiliary connecting electrode L11 is electrically connected with the third connection electrode L3 through a via V3, and the third connection electrode L3 is electrically connected with the active layer A8 of the voltage stabilizing transistor T8 through a via 07, so, the first connection electrode L1 is electrically connected with the active layer A8 of the voltage stabilizing transistor T8 sequentially through the first auxiliary connecting electrode L11 and the third connection electrode L3, so that the gate electrode G2 of the first control transistor T2, the second electrode of the voltage stabilizing transistor T8, the first electrode of the second denoising transistor T7, and the first electrode of the input transistor T1 are all electrically connected with the first node N1.

For example, referring to Fig. 2 and Fig. 3B, the electrode in which the gate electrode G2 of the first control transistor T2 is located (i.e., the first auxiliary connecting electrode L11) includes a tilt portion a; an extension direction of the tilt portion a intersects with both the first direction D1 and the second direction D2; an end of the tilt portion a that is close to the voltage stabilizing transistor T8 in the second direction D2 is electrically connected with the third connection electrode L3 through a third via (i.e., the above-described via V3), and the third connection electrode L3 serves as the second electrode of the voltage stabilizing transistor T8, thereby implementing an electrical connection between the gate electrode G2 of the first control transistor T2 and the second electrode of the voltage stabilizing transistor T8.

For example, the electrode in which the gate electrode G2 of the first control transistor T2 is located (i.e., the first auxiliary connecting electrode L11) further includes a vertical portion b connected with the tilt portion a and extending along the second direction D2; the vertical portion b extends through the space SP; and an end of the vertical portion b that is away from the tilt portion a in the second direction D2 is electrically connected with the first connection electrode L1 through a fourth via (i.e., the via V4). Since the first control transistor T2 and the voltage stabilizing transistor T8 are staggered from each other in the first direction, crossover of the tilt portion a in the first direction D1 and the second direction D2 cooperates with crossover of the vertical portion b in the second direction D2, which may reasonably utilize limited space, so that the gate electrode G2 of the first control transistor T2, the second electrode of the voltage stabilizing transistor T8, the first electrode of the second denoising transistor T7, and the first electrode of the input transistor T1 are all coupled to the first node N1.

For example, a gate electrode G7 of the second denoising transistor T7 and the first electrode of the output transistor T5 are both electrically connected with the second clock signal terminal CB to receive the second clock signal. Referring to Fig. 2, Fig. 3B, and Fig. 3D to Fig. 3E, an electrode in which the gate electrode G7 of the second denoising transistor T7 is located (i.e., the second auxiliary connecting electrode L12) is in a strip shape extending along the second direction D2, and the first electrode of the output transistor T5 includes a second connection electrode L2; for example, the gate electrode G7 of the second denoising transistor T7 is located in the first conductive layer 320, the second connection electrode L2 is located in the third conductive layer 340, an end close to the output transistor T5 in the second direction D2 of the electrode in which the gate electrode G7 of the second denoising transistor T7 is located (i.e., the second auxiliary connecting electrode L12) is electrically connected with the second connection electrode L2 through a fifth via V5, and the second connection electrode L2 is electrically connected with the second clock signal line GCB to be electrically connected with the second clock signal terminal CB, so that the gate electrode G7 of the second denoising transistor T7 and the first electrode of the output transistor T5 are all electrically connected with the second clock signal terminal CB.

For example, referring to Fig. 2 and Fig. 3E, the second connection electrode L2 includes a first strip portion L21 extending along the first direction D1; an end close to the output transistor T5 in the second direction D2 of the electrode in which the gate electrode G7 of the second denoising transistor T7 is located (i.e., the second auxiliary connecting electrode L12) is electrically connected with a first end of the first strip portion L21 in the first direction D1 through the fifth via V5; and the second connection electrode L2 is electrically connected with the clock signal terminal. For example, the shift register unit 104 further includes a third connection electrode L3; the second connection electrode L2 is electrically connected with the second clock signal line GCB through the third connection electrode L3; and the third connection electrode L3 and the second connection electrode L2 are arranged in different layers, to reduce wiring density of conductive layers in which the two are respectively located, so as to ensure display quality, and at a same time, reduce space occupied by each conductive layer and difficulties in wiring, to reduce the border size of the display substrate 10. For example, the third connection electrode L3 and the second auxiliary connecting electrode L12 are arranged in a same layer, for example, both are located in the first conductive layer 320; = the second connection electrode L2 and the second clock signal line GCB are arranged in a same layer, for example, both are located in the third conductive layer 340; a second end of the first strip portion L21 of the second connection electrode L2 in the first direction D1 is electrically connected with a first end of the third conductive layer 340 in the first direction D1 through a via V06; a second end of the third connection electrode L3 in the first direction D1 is electrically connected with the second clock signal line GCB through a via V08. For example, the second end of the third conductive layer 340 in the first direction D1 is electrically connected with the second clock signal line GCB through a plurality of vias V08, to ensure reliability of electrical connection with the second clock signal line GCB; and space at the connection is relatively sufficient, allowing for arrangement of a plurality of vias V08.

Referring to Fig. 2 and Fig. 3E, the second connection electrode L2 further includes a plurality of second strip portions L22 extending along the second direction D2 and arranged in the first direction D1; the plurality of second strip portions L22 are connected with the first strip portion L21 and overlap with the first output semiconductor portion A11 and the second output semiconductor portion A12, respectively; each second strip portion L22 is electrically connected with the first output semiconductor portion A11 through a via V18, and electrically connected with the second output semiconductor portion A12 through a via V19, to compose the first electrode of the output transistor T5. Thus, the first electrode of the output transistor T5 is electrically connected with the second clock signal line GCB sequentially through the first strip portion L21 and the third connection electrode L3, to implement electrical connection between the first electrode of the output transistor T5 and the second clock signal terminal CB.

For example, the first clock signal line GCK and the second power line VGL are both located on a side of the second clock signal line GCB that is close to the shift register unit 104, that is, located on a side of the second clock signal line GCB that is close to the display region 102, to facilitate electrical connection of the first clock signal line GCK and the second power line VGL with the transistor in the shift register unit 104; the third conductive layer 340 crosses the first clock signal line GCK and the second power line VGL along the first direction D1 and is electrically connected with the second clock signal line GCB; moreover, in order to facilitate fabricating the respective signal lines, the first clock signal line GCK, the second power line VGL, and the second clock signal line GCB are all arranged in a same layer; so the third conductive layer 340 arranged in a layer different from the second connection electrode L2 is used for adaptation, so that the first clock signal line GCK and the second power line VGL may be bypassed. Of course, an arrangement order of the first clock signal line GCK, the second power line VGL, and the second clock signal line GCB in the first direction D1 is not limited to such case. Regardless of the order of arrangement, among these signal lines, a signal line arranged further away from the shift register unit 104 in the first direction is electrically connected with the transistor in the shift register unit 104 through an adapter electrode (similar to the third connection electrode L3) arranged in a layer different from these signal lines, and the adapter electrode crosses a signal line closer to the shift register unit 104, so as to narrow the border and ensure display quality at a same time.

For example, referring to Fig. 2, in the first direction D1, the second power line VGL is located on a side of the first clock signal line GCK and the second clock signal line GCB that is close to the shift register unit 104; in the first direction D2, the second power line VGL is adjacent to both the second control transistor T3 and the voltage stabilizing transistor T8, for example, adjacent to both the active layer A3 of the second control transistor T3 and the active layer A8 of the voltage stabilizing transistor T8, that is, no other transistor or capacitor is provided between the second power line VGL and the second control transistor T3 in the first direction D2, to facilitate electrical connection of the second power line VGL with the second electrode of the second control transistor T3, and facilitate electrical connection of the second power line VGL with the gate electrode G8 of the voltage stabilizing transistor T8.

For example, referring to Fig. 2 and Fig. 3D to Fig. 3E, the shift register unit 104 further includes a sixth connection electrode L6; the sixth connection electrode L6 is electrically connected with the second power line VGL and protrudes from the second power line VGL along the first direction D1; for example, the sixth connection electrode L6 and the second power line VGL compose a continuous integral structure; for example, the sixth connection electrode L6 is located in the third conductive layer 340 and is electrically connected with the active layer A3 of the second control transistor T3 through a via V12, to implement electrical connection between the second electrode of the second control transistor T3 and the second power line VGL to receive the second voltage. In this way, connection between the second control transistor T3 and the second power line VGL may be implemented by using the sixth connection electrode with a shorter length, and limited space may be reasonably utilized for layout of the second control transistor T3 and the second power line VGL, which is favorable for reducing the border width of the display substrate.

For example, referring to Fig. 2, Fig. 3A and Fig. 3D to Fig. 3E, the shift register unit 104 further includes a seventh connection electrode L7; the connecting electrode L7 includes a first horizontal portion L71 and a second horizontal portion L72 respectively extending along the first direction D1, as well as a vertical portion L73 extending along the second direction D2 and connecting the first horizontal portion L71 and the second horizontal portion L72; the first horizontal portion L71 and the second horizontal portion L72 are arranged in the second direction; an orthographic projection of the first horizontal portion L71 on the main surface of the base substrate 1 is substantially aligned with an orthographic projection of the active layer A2 of the first control transistor T2 on the main surface of the base substrate 1 in the first direction D1; a first end of the first horizontal portion L71 in the first direction D1 is electrically connected with the active layer A2 of the first control transistor T2 through a via V13; and a second end of the first horizontal portion L71 in the first direction D1 is electrically connected with the first electrode CE11 of the first capacitor C2 through a via V14; an orthographic projection of the second horizontal portion L72 on the main surface of the base substrate 1 is substantially aligned with an orthographic projection of the active layer A3 of the second control transistor T3 on the main surface of the base substrate 1 in the first direction D1; and a first end of the second horizontal portion L72 in the first direction D1 is electrically connected with the active layer A3 of the second control transistor T3 through a via V15. The gate electrode of the output control transistor T4, the first electrode CE11 of the first capacitor C2, and the gate electrode of the first denoising transistor T6 compose an integral structure, so that the first electrode of the first control transistor T2, the first electrode of the second control transistor T3, the gate electrode of the output control transistor T4, the first electrode CE11 of the first capacitor C2, and the gate electrode of the first denoising transistor T6 are all electrically connected with the second node N2. Meanwhile, space is reasonably utilized through layout of the seventh connection electrode L7, so that the structure is compact, which is favorable for reducing the border. In addition, a trance of the integral structure composed of the seventh connection electrode L7, the active layer A2 of the first control transistor T2 and the active layer A3 of the second control transistor T3 is arranged neatly, which is favorable for improving a fabrication yield of the display substrate.

For example, referring to Fig. 2 and Fig. 3B, the gate electrode G1 of the input transistor T1 and the gate electrode G3 of the second control transistor T3 compose a continuous integral structure; for example, the input transistor T1 has a double-gate structure, for example, the integral structure composed of the gate electrode G1 of the input transistor T1 and the gate electrode G3 of the second control transistor T3 includes a first-direction strip portion L13 extending along the first direction D1, as well as a first portion and a second portion that are connected with the first-direction strip portion L13 and extend respectively towards a first side of the first-direction strip portion L13 in the second direction D2 and towards a second side of the first-direction strip portion L13 in the second direction D2; the first portion includes the gate electrode G1 of the input transistor T1; the second portion includes the gate electrode G3 of the second control transistor T3; a first end of the first-direction strip portion L13 that is away from the display region in the first direction D1 is electrically connected with the first clock signal line GCK through a via V09; for example, the shift register unit 104 further includes a fourth connection electrode L4, for example, the fourth connection electrode L4 is located; and a second end of the first-direction strip portion L13 that is close to the display region in the first direction D1 is electrically connected with a fourth connecting structure L4 through a via V10; the fourth connecting structure L4 is electrically connected with the active layer A2 of the first control transistor T2 through a via V11, so that the gate electrode G1 of the input transistor T1, the gate electrode G3 of the second control transistor T3, and the second electrode of the first control transistor T2 are all connected with the first clock signal terminal CK to receive the first clock signal.

For example, referring to Fig. 2 and Fig. 3B, the display substrate 10 further includes an output signal line OL electrically connected with the output terminal GOUT, for example, the output signal line OL and the gate electrode G5 of the output transistor T5 are arranged in a same layer, and both are located in the first conductive layer 320, so that the output signal line OL is electrically connected with the gate electrode of the transistor of the pixel circuit in the display region 102 that is located in the first conductive layer after entering the display region 102. A portion of the output signal line OL that is located in the non-display region 102B includes a first-direction portion OL1 and a second-direction portion OL2; referring to Fig. 3E, the fifth connection electrode L5 is located in the third conductive layer 340; the first-direction portion OL1 of the output signal line OL extends along the first direction D1; one end of the first-direction portion OL1 that is away from the display region 102 in the first direction D1 is electrically connected with the electrode in which the second electrode of the output transistor T5 is located (i.e., the fifth connection electrode L5) through a first output via V001, so that the second electrode of the output transistor T5 is electrically connected with the output terminal GOUT; the second-direction portion OL2 of the output signal line OL is connected with the first-direction portion OL1, is located on a side of the first-direction portion OL1 that is close to the display region 102, and extends along the second direction D2 as a whole to further enter the display region 102.

For example, referring to Fig. 2, Fig. 3B and Fig. 3E, the electrode in which the second electrode of the output transistor T5 is located (i.e., the fifth connection electrode L5) further includes a plurality of strip-shaped extending portions L52 that are connected with a strip-shaped main body portion L51, located on a first side of the strip-shaped main body portion L51 in the second direction D2, spaced apart from each other and extend along the second direction D2, and includes a protrusion portion L53 located on the first side of the strip-shaped main body portion L51 in the second direction D2; the protrusion portion L53 protrudes from the strip-shaped main body portion L51 in the second direction D2; orthographic projections of the plurality of strip-shaped extending portions L52 on the base substrate 1 overlap at least partially with both an orthographic projection of the first output semiconductor portion A11 on the base substrate 1 and an orthographic projection of the second output semiconductor portion A12 on the base substrate 1; the protrusion portion L53 is located on a first side of the integral structure composed of the first output semiconductor portion A11 and the second output semiconductor portion A12 in the second direction D2; the first-direction portion OL1 of the output signal line OL is located on a second side of the integral structure composed of the first output semiconductor portion A11 and the second output semiconductor portion A12 in the second direction D2; an end of the first-direction portion OL1 that is away from the display region 102 in the first direction D1 is connected with the protrusion portion L53 through the first output via V001; the second-direction D2 portion is connected with the first-direction D1 portion, is located on a side of the first-direction D1 portion that is close to the display region 102, and extends along the second direction D2 as a whole. For example, the output signal line OL is routed around a corner of the second output semiconductor portion A12 to reasonably wire the output signal line, so as to save space and minimize the border width of the display substrate 10.

For example, in the embodiment shown in Fig. 2, an end portion of the main body portion L51 of the fifth connection electrode L5 that is close to the second capacitor C2 is electrically connected with the second electrode CE22 of the second capacitor C2 through a via V01, so that the second electrode of the output transistor T5 and the second electrode CE22 of the second capacitor C2 are both electrically connected with the output terminal GOUT.

For example, in the embodiment shown in Fig. 2, the first power line VGH is located on a side of the second electrode of the output transistor T5 that is close to the display region 102 in the first direction D1, and an orthographic projection of the first power line VGH on the base substrate 1 overlaps with an orthographic projection of the output signal line OL on the base substrate 1, to avoid the first power line from occupying too much space in the first direction D1, which is favorable for reducing the border width of the display substrate 10.

For example, referring to Fig. 3B, the electrode in which the gate electrode G5 of the output transistor T5 is located and the first electrode CE21 of the second capacitor C2 compose a continuous integral structure, so as to implement electrical connection between the gate electrode G5 of the output transistor T5 and the first electrode CE21 of the second capacitor C2, and simplify the structure and the fabrication process of the display substrate.

For example, in the embodiment shown in Fig. 2, among the first power line VGH, the second power line VGL, the trigger signal line GSTV, the first clock signal line GCK, and the second clock signal line GCB, only the first power line VGH overlaps with the shift register unit 104 in the direction perpendicular to the base substrate 1, for example, the first power line VGH overlaps at least with the output control transistor T4. For example, referring to Fig. 3E, the first power line VGH, the second power line VGL, the trigger signal line GSTV, the first clock signal line GCK, and the second clock signal line GCB are all arranged in a same layer as the second electrode of the second control transistor T3, to form structures arranged in a same layer by using a same patterning process on a same film layer, so as to simplify the fabrication process.

Further, in other embodiments, other signal lines may also overlap with the shift register unit 104 in the direction perpendicular to the base substrate 1, for example, overlap with structures such as transistors, capacitors, etc. in the shift register unit 104. For example, on the basis that the first power line VGH overlaps with the shift register unit 104 in the direction perpendicular to the base substrate 1, at least one selected from the group consisting of the second power line VGL, the trigger signal line GSTV, the first clock signal line GCK and the second clock signal line GCB overlaps with the shift register unit 104 in the direction perpendicular to the base substrate 1; meanwhile, for example, the signal line overlapping with the shift register unit 104 in the direction perpendicular to the base substrate 1 is arranged in a layer different from the second electrode of the second control transistor T3, so that the signal line passes through a connection pad arranged in a same layer as the second electrode of the second control transistor T3 to be electrically connected with a lower layer (e.g., the semiconductor layer 310), so that structures in other conductive layers that do not require electrical connection with the signal line are bypassed.

For example, Fig. 5A is a schematic diagram of layout of a portion of another display substrate that includes a shift register unit provided by at least one embodiment of the present disclosure; Fig. 6A is a cross-sectional schematic diagram along a B1-B2 line in Fig. 5A; and Fig. 6B is a cross-sectional schematic diagram along a C1-C2 line in Fig. 5A. In the embodiment shown in Fig. 5A, the display substrate 10 still includes the semiconductor layer 310, the first conductive layer 320, the second conductive layer 330, the third conductive layer 340, and the fourth conductive layer 350 arranged sequentially in the direction perpendicular to the main surface of the base substrate 1. As described above, the display substrate 10 includes the second power line VGL and the trigger signal line GSTV; the second power line VGL is configured to supply the second voltage to the shift register unit 104, the first electrode of the second control transistor T3 is connected with the second node N2, and the second electrode of the second control transistor T3 is connected with the second power line to receive the second voltage; the display substrate includes a plurality of cascaded shift register units 104; the first electrode of the input transistor T1 in the first-stage shift register unit 104 is connected with the input terminal; the input terminal is configured to be connected with the trigger signal line to receive the trigger signal from the trigger signal line as the input signal; the first clock signal line GCK is configured to supply the first clock signal to the shift register unit 104; and the second clock signal line GCB is configured to supply the second clock signal to the shift register unit 104. The display substrate shown in Fig. 5A and the display substrate shown in Fig. 2 have differences below.

For example, referring to Fig. 5A and Fig. 6A, the second power line VGL overlaps with the shift register unit 104 in the direction perpendicular to the base substrate 1 and is arranged in a layer different from the second electrode of the second control transistor T3. For example, the second power line VGL overlaps with the second control transistor T3 of the shift register unit 104. For example, referring to Fig. 5A and Fig. 6A, that the second power line VGL extend along the second direction D2 as a whole refers to that a portion of the second power line that is located in the non-display region 102B provided with the shift register unit extends along the second direction D2, which is also the case for other signal lines such as the first power line VGH, the first clock signal line GCK, the second clock signal line GCB, and the trigger signal line GSTV, etc. The second power line VGL at least partially overlaps with the electrode in which the gate electrode G3 of the second control transistor T3 is located in the direction perpendicular to the base substrate, and at least partially overlaps with the second electrode of the second control transistor T3 in the direction perpendicular to the base substrate 1; the second power line VGL is arranged in a layer different from the second electrode of the second control transistor T3; in the direction perpendicular to the main surface of the base substrate 1, the second electrode of the second control transistor T3 is located between the second power line VGL and the electrode in which the gate electrode G3 of the second control transistor T3 is located; the second electrode of the second control transistor T3 includes a portion that does not overlap with the electrode in which the gate electrode G3 of the second control transistor T3 is located in the direction perpendicular to the main surface of the base substrate 1; the second power line VGL is electrically connected with the second electrode of the second control transistor T3 through a first power via VP1; and the second electrode of the second control transistor T3 is electrically connected with the active layer A2 of the second control transistor T3 through a first auxiliary via VA1.

For example, as shown in Fig. 5B to Fig. 5D, the structures of the third conductive layer 340, the third insulation layer ILD3, and the fourth conductive layer 350 are different from the structures of the corresponding layers according to the embodiment shown in Fig. 2.

Combining Fig. 5A, Fig. 5B to Fig. 5D, and Fig. 6A, the shift register unit 104 includes a first connection pad AP1; the first connection pad AP1 serves as the second electrode of the second control transistor T3. For example, the first connection pad AP1 is located in the third conductive layer 340; the second power line VGL is located in the fourth conductive layer 350; the second power line VGL is electrically connected with the first connection pad AP1 through the first power via VP1 running through the fourth insulation layer IDL4; and the first connection pad AP1 is electrically connected with the active layer A3 of the second control transistor T3 through the first auxiliary via VA1 running through the first insulation layer IDL1, the second insulation layer IDL2, and the third insulation layer IDL3.

As described above, the shift register unit 104 further includes the voltage stabilizing circuit 1046; the voltage stabilizing circuit 1046 is connected with the first node N1 and the third node N3, and is configured to stabilize the level of the third node N3; the control terminal of the output circuit 1043 is connected with the third node N3; the output circuit 1043 is configured to output the output signal to the output terminal GOUT under control of the level of the third node N3; the voltage stabilizing circuit 1046 includes the voltage stabilizing transistor T8; the active layer A8 of the voltage stabilizing transistor T8 and the second capacitor C2 are both located on the first side of the integral structure composed of the first output semiconductor portion A11 and the second output semiconductor portion A12 in the first direction D1; and in the embodiment shown in Fig. 5A, the first side is a side away from the display region 102. For example, referring to Fig. 5A and Fig. 6B, the second power line VGL at least partially overlaps with the voltage stabilizing transistor T8 in the direction perpendicular to the base substrate 1; for example, the second power line VGL at least partially overlaps with the electrode in which the gate electrode G8 of the voltage stabilizing transistor T8 is located in the direction perpendicular to the base substrate 1; and the second power line VGL is electrically connected with the electrode in which the gate electrode G8 of the voltage stabilizing transistor T8 is located through a second power via VP2.

For example, combining Fig. 5A, Fig. 5B to Fig. 5D, and Fig. 6B, the shift register unit 104 includes a second connection pad AP2; the second connection pad AP2 is located in the third conductive layer 340; the second power line VGL is located in the fourth conductive layer 350; the second power line VGL is electrically connected with the second connection pad AP2 through the second power via VP2 running through the fourth insulation layer IDL4; and the second connection pad AP2 is electrically connected with the electrode in which the gate electrode G8 of the voltage stabilizing transistor T8 is located through a second auxiliary via VA2 running through the first insulation layer IDL1, the second insulation layer IDL2, and the third insulation layer IDL3.

For example, referring to Fig. 5A, the second power line VGL also at least partially overlaps with the input transistor T1 and the second capacitor C2 in the direction perpendicular to the main surface of the base substrate 1, that is, at least partially overlaps with the input transistor T1, the second control transistor T3, the voltage stabilizing transistor T8, and the second capacitor C2 in the second direction D2, so as to reduce a width of the shift register unit 104 in the first direction D1.

For example, in the embodiment shown in Fig. 5A, the trigger signal line GSTV, the first power line VGH, and the second power line VGL all overlap with the shift register unit 104 in the direction perpendicular to the main surface of the base substrate 1, so as to further prevent these signal lines from additionally occupying space in a region outside the shift register unit 104, which is favorable for reducing the border width.

For example, in the embodiment shown in Fig. 5A, a length/height ratio of a shift register unit is approximately 1.1:1; for example, one shift register unit has a height of 100.8 µm in the second direction D2, and a length of 108 µm in the first direction D1, which further reduces the length/height ratio of the shift register unit as compared with the embodiment shown in Fig. 2, so as to narrow the border.

For example, in the embodiment shown in Fig. 5A, the trigger signal line GSTV extends along the second direction D2 as a whole; and the trigger signal line GSTV is located between the first power line VGH and the second power line VGL. For example, the trigger signal line GSTV overlaps with the input transistor T1 and the output transistor T5.

For example, in the first-stage shift register unit, the trigger signal line GSTV at least partially overlaps with the first electrode of the input transistor T1 of the first-stage shift register unit 104 in the direction perpendicular to the main surface of the base substrate 1; the trigger signal line GSTV is electrically connected with the first electrode of the input transistor T1 of the first-stage shift register unit 104 through a trigger via, to supply a trigger signal to the input transistor T1 of the first-stage shift register unit 104.

For example, in some embodiments, in a non-first-stage shift register unit 104, the trigger signal line GSTV may overlap with any structure of the shift register unit 104 without being electrically connected with other structure through a via.

The description of the embodiment shown in Fig. 2 may be referred to for the structures according to the embodiment shown in Fig. 5A that may be seen in other diagrams and are the same as those according to the embodiment shown in Fig. 2; and no details will be repeated here.

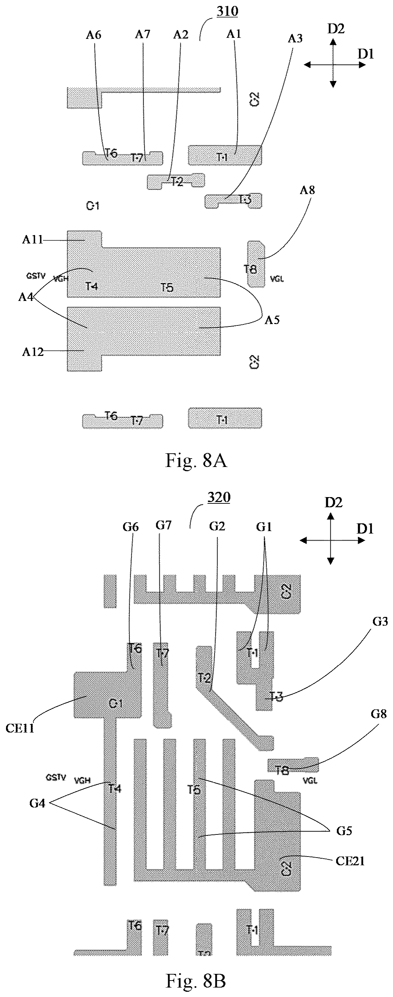

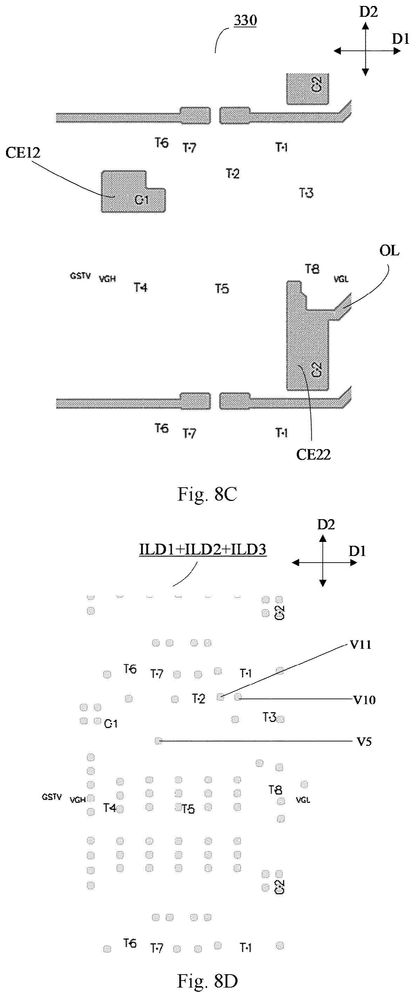

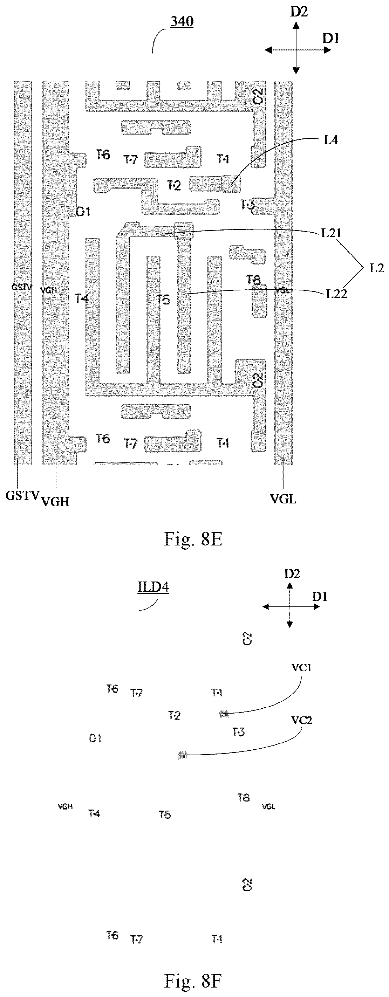

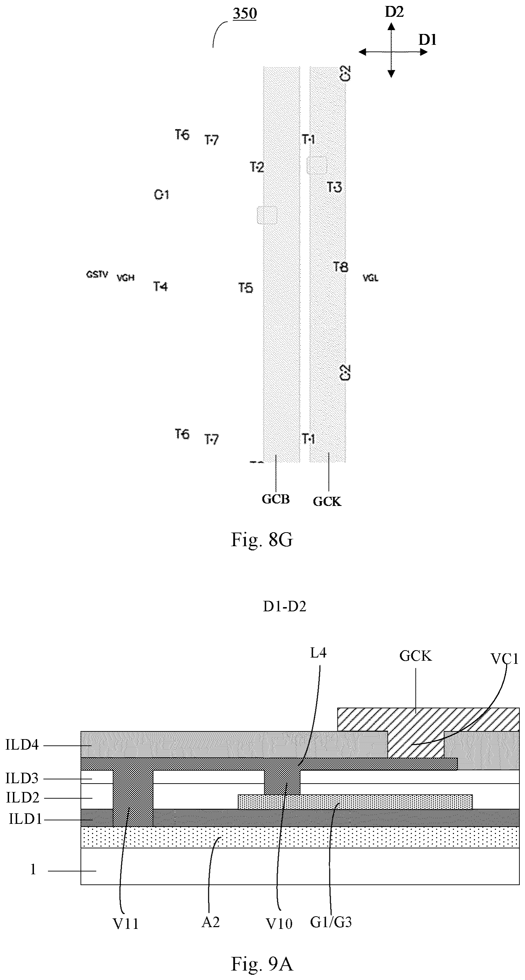

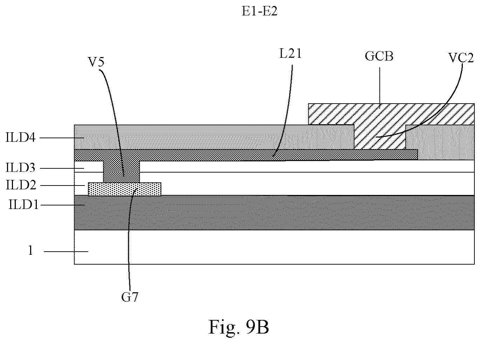

Fig. 7 is a schematic diagram of layout of a portion of another display substrate that includes a shift register unit provided by at least one embodiment of the present disclosure; and Fig. 8A to Fig. 8G respectively show planar structural schematic diagrams of respective layers of the shift register unit of the display substrate shown in Fig. 7. Fig. 9A is a cross-sectional schematic diagram along a D1-D2 line in Fig. 7; and Fig. 9B is a cross-sectional schematic diagram along an E1-E2 line in Fig. 7. In the embodiment shown in Fig. 7, the display substrate 10 still includes the semiconductor layer 310, the first conductive layer 320, the second conductive layer 330, the third conductive layer 340, and the fourth conductive layer 350 arranged sequentially in the direction perpendicular to the main surface of the base substrate 1. The display substrate shown in Fig. 7 and the display substrate shown in Fig. 2 have differences below.

For example, referring to Fig. 7, Fig. 8B, Fig. 8F to Fig. 8G and Fig. 9A, the first clock signal line GCK extends along the second direction D2 and at least partially overlaps with the shift register unit 104 in the direction perpendicular to the main surface of the base substrate 1. For example, the first clock signal line GCK at least partially overlaps with the electrode in which the gate electrode G1 of the input transistor T1 and the gate electrode G3 of the second control transistor T3 are located in the direction perpendicular to the main surface of the base substrate 1; for example, the gate electrode G1 of the input transistor T1 and the gate electrode G3 of the second control transistor T3 compose a continuous integral structure; the first clock signal line GCK is electrically connected with the electrode in which the gate electrode G1 of the input transistor T1 and the gate electrode G3 of the second control transistor T3 of the first-stage shift register unit 104 are located through a first clock via VC1 running through the fourth insulation layer IDL4. In this way, the shift register unit is ensured to execute a normal driving function, while avoiding the first clock signal line GCK from occupying space outside the shift register unit 104 to further reduce the border width of the display substrate.

For example, in the embodiment shown in Fig. 7, a length/height ratio of a shift register unit is approximately 1:1; for example, one shift register unit has a height of 100.8 µm in the second direction D2, and a length of 97 µm in the first direction D1, which further reduces the length/height ratio of the shift register unit as compared with the embodiment shown in Fig. 5A, so as to narrow the border.

Referring to Fig. 9A, the first clock signal line GCK is located in the fourth conductive layer 350, and is electrically connected with the fourth connection electrode L4 located in the third conductive layer 340 through the first clock via VC1 running through the fourth insulation layer IDL4; the fourth connection electrode L4 is electrically connected with the electrode in which the gate electrode G1 of the input transistor T1 and the gate electrode G3 of the second control transistor T3 are located through the via V10 running through the first insulation layer IDL1 and the second insulation layer IDL2; moreover, an end of the fourth connection electrode L4 that is away from the first clock signal line GCK in the first direction D1 is electrically connected with the active layer A2 of the first control transistor T2 through the via V10 running through the first insulation layer IDL1, the second insulation layer IDL2, and the third insulation layer IDL3, so that the gate electrode G1 of the input transistor T1, the gate electrode G3 of the second control transistor T3, and the second electrode of the first control transistor T2 are all electrically connected with the first clock signal line GCK, so as to be all connected with the first clock signal terminal CK to receive the first clock signal.

For example, the first clock signal line GCK also overlaps with the voltage stabilizing transistor T8 and the second capacitor C2.

For example, referring to Fig. 7, Fig. 8B, Fig. 8F to Fig. 8G and Fig. 9B, the second clock signal line GCB extends along the second direction D2 and at least partially overlaps with the shift register unit 104 in the direction perpendicular to the main surface of the base substrate 1. For example, the second clock signal line GCB at least partially overlaps with the electrode in which the first electrode of the output transistor T5 is located in the direction perpendicular to the base substrate 1; and the second clock signal line GCB is electrically connected with the electrode in which the first electrode of the output transistor T5 is located through a second clock via VC2 running through the fourth insulation layer IDL4. In this way, the shift register unit is ensured to execute a normal driving function, while avoiding the second clock signal line GCB from occupying space outside the shift register unit 104 to further reduce the border width of the display substrate.

For example, referring to Fig. 8B, Fig. 8E and Fig. 9B, the electrode in which the gate electrode G7 of the second denoising transistor T7 is located is in a strip shape extending along the second direction D2; the first electrode of the output transistor T5 includes a second connection electrode L2; the second connection electrode L2 includes a first strip portion L21 extending along the first direction D1; the second connection electrode L2 is located in the third conductive layer 340; the second clock signal line GCB is located in the fourth conductive layer 350; one end close to the output transistor T5 in the second direction D2 of the electrode in which the gate electrode G7 of the second denoising transistor T7 is located is electrically connected with the first strip portion L21 through a fifth via V5 running through the second insulation layer IDL2 and the third insulation layer IDL3; the second clock signal line GCB at least partially overlaps with the first strip portion L21 of the second connection electrode L2 in the direction perpendicular to the base substrate 1; and the second clock signal line GCB is electrically connected with the first strip portion L21 of the second connection electrode L2 through the second clock via VC2 running through the fourth insulation layer IDL4, so that the gate electrode G7 of the second denoising transistor T7 and the first electrode of the output transistor T5 are both connected with the second clock signal terminal CB.

For example, an end close to the output transistor T5 in the second direction D2 of the electrode in which the gate electrode G7 of the second denoising transistor T7 is located is electrically connected with the first end of the first strip portion L21 in the first direction D1 through the fifth via V5;

For example, the second clock signal line GCB also overlaps with the first control transistor T2 and the output transistor T5; for example, the second clock signal line GCB the first output semiconductor portion A11 and the second output semiconductor portion A12.

For example, the active layer A8 of the voltage stabilizing transistor T8 and the second capacitor C2 are both located on the first side of the integral structure composed of the first output semiconductor portion A11 and the second output semiconductor portion A12 in the first direction D1. In the embodiment shown in Fig. 7, the first side is a side close to the display region 102.

For example, in the embodiment shown in Fig. 7, the second capacitor C2 is located on a side of the integral structure composed of the first output semiconductor portion A11 and the second output semiconductor portion A12 that is close to the display region 102 in the first direction D1. The display substrate 10 further includes an output signal line OL; the output signal line OL is electrically connected with the second electrode CE22 of the second capacitor C2; the second electrode CE22 of the second capacitor C2 is electrically connected with the electrode in which the second electrode of the output transistor T5 is located through a second output via V002, so that the second electrode of the output transistor T5 is electrically connected with the output terminal GOUT. For example, the output signal line OL and the second electrode CE22 of the second capacitor C2 are arranged in a same layer and compose an integral structure. In this way, signal output may be implemented without additionally electrically connecting the second electrode CE22 of the second capacitor C2 or the second electrode of the output transistor T5 with the output signal line through an adapter hole, which simplifies the structure and the fabrication process of the shift register unit.

The description of the embodiment shown in Fig. 2 may be referred to for the structures according to the embodiment shown in Fig. 7 that may be seen in other diagrams and are the same as those according to the embodiment shown in Fig. 2; the positions of other structures change with changes in the positions of the active layer A8 of the voltage stabilizing transistor T8 and the second capacitor C2 in the first direction D1; and no details will be repeated here.

Fig. 10 is a schematic diagram of layout of a portion of another display substrate that includes a shift register unit provided by at least one embodiment of the present disclosure. Referring to Fig. 10, for example, the first clock signal line GCK, the second clock signal line GCB, the trigger signal line GSTV, the first power line VGH, and the second power line VGL all overlap with the shift register unit 104 in the direction perpendicular to the main surface of the base substrate 1, so as to further avoid these signal lines from additionally occupying space in a region outside the shift register unit 104, which is favorable for reducing the border width.

For example, in the embodiment shown in Fig. 10, a length/height ratio of a shift register unit is approximately 0.75:1; for example, one shift register unit has a height of 100.8 µm in the second direction D2, and a length of 75 µm in the first direction D1, which further reduces the length/height ratio of the shift register unit as compared with the embodiment shown in Fig. 7, so as to narrow the border.

For example, the first clock signal line GCK, the second clock signal line GCB, the trigger signal line GSTV, the first power line VGH, and the second power line VGL are all arranged in a same layer and are all arranged in a layer different from the first electrode of the output transistor T1, so as to provide sufficient space for wiring the first clock signal line GCK, the second clock signal line GCB, the trigger signal line GSTV, the first power line VGH, and the second power line VGL within a space range overlapping with the shift register unit 104, to keep a sufficient separation distance between traces in a same layer to avoid adhesion and short circuit. Thus, in the embodiment shown in Fig. 2, there is enough space to avoid the first clock signal line GCK, the second clock signal line GCB, the trigger signal line GSTV, the first power line VGH, and the second power line VGL from overlapping with traces of other layers as much as possible, so as to avoid interference caused by mutual coupling of overlapping traces in different layers.

For example, referring to Fig. 10, in a non-first-stage shift register unit 104, the trigger signal line GSTV extends along the second direction D2 and at least partially overlaps with the active layer of the first denoising transistor T6 and the active layer of the second denoising transistor T7. Because the positions of the active layer of the first denoising transistor T6 and the active layer of the second denoising transistor T7 are not provided with other signal lines extending along the second direction D2 that need to be electrically connected with other structures through vias, the space may be utilized to arrange the trigger signal line GSTV, so that the trigger signal line GSTV does not occupy additional space outside the shift register unit 104, which is favorable for reducing the border width. Meanwhile, the arrangement mode in which the trigger signal line GSTV overlaps with the shift register unit 104 will not affect arrangement of other structures of the shift register unit 104, which ensures display quality of the display substrate.

Of course, the position of the trigger signal line GSTV may also be the same as in the embodiment shown in Fig. 5A.

For example, adaption modes of the first clock signal line GCK, the second clock signal line GCB, the first power line VGH, and the second power line VGL are respectively the same as those in the foregoing embodiments, and the corresponding foregoing descriptions may be respectively referred to.

At least one embodiment of the present disclosure further provides a display device. Fig. 11 is a schematic diagram of a display device provided by at least one embodiment of the present disclosure. Referring to Fig. 11, the display device 100 provided by at least one embodiment of the present disclosure includes any type of display substrate 10 provided by the embodiment of the present disclosure.

For example, the display device 100 further includes a plurality of pixel units located in the display region 102 and arranged in an array. At least some pixel units among the plurality of pixel units include light emitting devices, for example, except a dummy pixel that does not play a role in display, each pixel unit includes a light emitting device. The output signal output by the output circuit 1043 of the shift register unit 104 serves as a gate scan signal to drive the light emitting devices of the plurality of pixel units to emit light.

For example, the display device 100 may be an OLED panel, an OLED television, a QLED panel, a QLED television, or may be a mobile phone, a tablet personal computer, a laptop, a digital photo frame, a navigator, and any other product or component having a display function. The display device 100 may further include other components, for example, a data driving circuit, a timing controller, etc., which will not be limited in the embodiments of the present disclosure.

It should be noted that, for clarity and conciseness, the embodiment of the present disclosure does not give all the component units of the display device. In order to implement basic functions of the display device, those skilled in the art may provide and arrange other structures not shown according to specific needs, which will not be limited in the embodiments of the present disclosure.

For technical effects of the display device 2 provided by the above-described embodiment, the technical effects of the display substrate 1 provided by the embodiments of the present disclosure may be referred to, and no details will be repeated here.

For the present disclosure, the following statements should be noted:
(1) The accompanying drawings involve only the structure(s) in connection with the embodiment(s) of the present disclosure, and other structure(s) can be referred to common design(s).
(2) In case of no conflict, the embodiments of the present disclosure and the features in the embodiments can be combined with each other to obtain new embodiments.

What have been described above are only specific implementations of the present disclosure, the protection scope of the present disclosure is not limited thereto, and the protection scope of the present disclosure should be based on the protection scope of the claims.

## Claims

1. A display substrate, comprising:
a base substrate, comprising a display region and a non-display region at least partially around the display region;
a shift register unit, arranged on the base substrate and located in the non-display region;
wherein
the shift register unit comprises an input circuit, an output circuit, a first control circuit, and an output control circuit;
the input circuit is configured to input an input signal to a first node in response to a first clock signal;
the output circuit is configured to output an output signal to an output terminal;
the first control circuit is configured to control a level of a second node in response to a level of the first node and the first clock signal;
the output control circuit is configured to control a level of the output terminal under control of the level of the second node;
the output control circuit comprises an output control transistor, the output circuit comprises an output transistor, a direction parallel to a direction from the non-display region to the display region is a first direction, the shift register unit comprises a first output semiconductor portion and a second output semiconductor portion that are spaced apart from each other in a second direction, the second direction intersects with the first direction, an integral structure composed of the first output semiconductor portion and the second output semiconductor portion comprises an active layer of the output control transistor and an active layer of the output transistor; and a length direction of a channel of the output control transistor and a length direction of a channel of the output transistor are both along the first direction.

2. The display substrate according to claim 1, wherein the input circuit comprises an input transistor, and the first control circuit comprises a first control transistor and a second control transistor,
an active layer of the input transistor, an active layer of the first control transistor, and an active layer of the second control transistor are all located on a first side of the integral structure composed of the first output semiconductor portion and the second output semiconductor portion in the second direction.

3. The display substrate according to claim 2, wherein the shift register unit further comprises a second control circuit, the second control circuit is connected with the first node and the second node, and is configured to control the level of the first node under control of the level of the second node and the second clock signal;
the second control circuit comprises a first denoising transistor and a second denoising transistor, an active layer of the first denoising transistor and an active layer of the second denoising transistor are both located on the first side of the integral structure composed of the first output semiconductor portion and the second output semiconductor portion in the second direction.

4. The display substrate according to any one of claims 1 to 3, wherein the active layer of the output control transistor and the active layer of the output transistor respectively comprise a plurality of sub-channel regions, and each of the output control transistor and the output transistor comprises at least one first sub-channel region and at least one second sub-channel region;
the at least one first sub-channel region of the output control transistor and the at least one first sub-channel region of the output transistor are located in the first output semiconductor portion and are arranged along the first direction; the at least one second sub-channel region of the output control transistor and the at least one second sub-channel region of the output transistor are located in the second output semiconductor portion and are arranged along the first direction.

5. The display substrate according to claim 4, wherein a length of the first output semiconductor portion in the first direction is greater than a length of the first output semiconductor portion in the second direction; and
a length of the second output semiconductor portion in the first direction is greater than a length of the second output semiconductor portion in the second direction.

6. The display substrate according to claim 3, wherein the output control circuit further comprises a first capacitor; a first electrode of the first capacitor is electrically connected with the second node, the display substrate further comprises a first power line; the first power line is configured to supply a first voltage to the shift register unit, and a second electrode of the first capacitor is electrically connected with the first power line;
the first capacitor is located on the first side of the integral structure composed of the first output semiconductor portion and the second output semiconductor portion in the second direction.

7. The display substrate according to claim 6, wherein in the second direction, the first capacitor is located between the active layer of the first denoising transistor and the integral structure composed of the first output semiconductor portion and the second output semiconductor portion;
the first electrode of the first capacitor is electrically connected with a gate electrode of the first denoising transistor and a gate electrode of the output control transistor, and the first electrode of the first capacitor, the gate electrode of the first denoising transistor and the gate electrode of the output control transistor compose a continuous integral structure;
an electrode in which the gate electrode of the output control transistor is located extends along the second direction from the first electrode of the first capacitor towards the integral structure composed of the first output semiconductor portion and the second output semiconductor portion; an orthographic projection of the gate electrode of the output control transistor on the base substrate at least partially overlaps with an orthographic projection of the first output semiconductor portion on the base substrate, and at least partially overlaps with an orthographic projection of the second output semiconductor portion on the base substrate;
an electrode in which the gate electrode of the first denoising transistor is located extends along the second direction from the first electrode of the first capacitor towards the active layer of the first denoising transistor, and an orthographic projection of the electrode in which the gate electrode of the first denoising transistor is located on the base substrate at least partially overlaps with an orthographic projection of the active layer of the first denoising transistor on the base substrate.

8. The display substrate according to claim 6 or 7, wherein the first power line extends along the second direction as a whole, and the first power line is located on a first side of an integral structure composed of the active layer of the input transistor, the active layer of the first control transistor, the active layer of the second control transistor, and the active layer of the second denoising transistor in the first direction;
an orthographic projection of the first power line on the base substrate overlaps with an orthographic projection of the second electrode of the first capacitor on the base substrate, and the first power line is electrically connected with the second electrode of the first capacitor through a first via; and,
the first power line and a first electrode of the output control transistor compose an integral structure, an orthographic projection of the first power line on the base substrate overlaps with both the orthographic projection of the first output semiconductor portion on the base substrate and the orthographic projection of the second output semiconductor portion on the base substrate, and the first power line is electrically connected with the first output semiconductor portion and the second output semiconductor portion through a second via.

9. The display substrate according to claim 8, wherein the first power line covers at least a portion of an edge of the first output semiconductor portion that extends along the second direction and at least a portion of an edge of the second output semiconductor portion that extends along the second direction.

10. The display substrate according to any one of claims 3 and 6 to 9, wherein the output circuit further comprises a second capacitor, a first electrode of the second capacitor is connected with a control terminal of the output circuit; and a second electrode of the second capacitor is connected with the output terminal;
the second capacitor is located on a side of the integral structure composed of the first output semiconductor portion and the second output semiconductor portion in the first direction.

11. The display substrate according to claim 10, wherein a length of the second capacitor in the second direction is greater than a length of the second capacitor in the first direction.

12. The display substrate according to claim 10 or 11, wherein an orthographic projection of the active layer of the second control transistor on a plane parallel to the first direction at least partially overlaps with an orthographic projection of the active layer of the input transistor on the plane parallel to the first direction, and at least partially overlaps with an orthographic projection of the second capacitor on the plane parallel to the first direction.

13. The display substrate according to any one of claims 10 to 12, wherein the active layer of the input transistor, the active layer of the first denoising transistor, and the active layer of the second denoising transistor are arranged in the first direction; and
the active layer of the input transistor, the active layer of the first control transistor, and the active layer of the second control transistor are arranged in the second direction.

14. The display substrate according to claim 13, wherein in the first direction, a space is between the active layer of the input transistor and the active layer of the second denoising transistor, and at least a portion of the active layer of the first control transistor overlaps with the space in the second direction;
a first electrode of the input transistor and a first electrode of the second denoising transistor are both connected with the first node, the first electrode of the input transistor and the first electrode of the second denoising transistor compose a continuous integral first connection electrode, the first connection electrode is at least partially located in the space, and an electrode in which a gate electrode of the first control transistor is located extends through the space to be electrically connected with the first connection electrode.

15. The display substrate according to claim 14, wherein each selected from a group consisting of the active layer of the input transistor, the active layer of the second denoising transistor, and the first connection electrode is in a strip shape extending along the first direction;
two ends of the first connection electrode in the first direction are respectively electrically connected with an end of the active layer of the input transistor and an end of the active layer of the second denoising transistor that are opposite to each other in the first direction.

16. The display substrate according to claim 14 or 15, wherein the shift register unit further comprises a voltage stabilizing circuit, the voltage stabilizing circuit is connected with the first node and the third node, and is configured to stabilize a level of the third node; the control terminal of the output circuit is connected with the third node, and the output circuit is configured to output the output signal to the output terminal under control of the level of the third node;
the voltage stabilizing circuit comprises a voltage stabilizing transistor, an active layer of the voltage stabilizing transistor and the second capacitor are both located on the first side of the integral structure composed of the first output semiconductor portion and the second output semiconductor portion in the first direction, and orthographic projections of the active layer of the voltage stabilizing transistor and the second capacitor on a plane parallel to the second direction both overlap at least partially with the orthographic projection of the integral structure composed of the first output semiconductor portion and the second output semiconductor portion on the plane parallel to the second direction;
the active layer of the voltage stabilizing transistor is located on a side of the second capacitor that is close to the input transistor in the second direction, and an orthographic projection of the active layer of the voltage stabilizing transistor on the plane parallel to the first direction at least partially overlaps with an orthographic projection of the second capacitor on the plane parallel to the first direction.

17. The display substrate according to any one of claims 14 to 16, wherein
the voltage stabilizing transistor is located on a side of the first control transistor that is close to the second capacitor in the second direction, and a first electrode of the voltage stabilizing transistor is electrically connected with the first electrode of the second capacitor;
an orthographic projection of the voltage stabilizing transistor on the plane parallel to the first direction does not overlap with an orthographic projection of the first control transistor on the plane parallel to the first direction, and overlaps with an orthographic projection of the second control transistor on the plane parallel to the first direction.

18. The display substrate according to claim 17, wherein an electrode in which the gate electrode of the first control transistor is located comprises a tilt portion, an extension direction of the tilt portion intersects with both the first direction and the second direction, and an end of the tilt portion that is close to the voltage stabilizing transistor in the second direction is electrically connected with the second electrode of the voltage stabilizing transistor through a third via.

19. The display substrate according to claim 18, wherein the electrode in which the gate electrode of the first control transistor is located further comprises a vertical portion connected with the tilt portion and extending along the second direction, the vertical portion extends through the space, and an end of the vertical portion that is away from the tilt portion in the second direction is electrically connected with the first connection electrode through a fourth via.

20. The display substrate according to claim 19, wherein a gate electrode of the second denoising transistor and a first electrode of the output transistor are both electrically connected with a second clock signal terminal to receive the second clock signal;
an electrode in which the gate electrode of the second denoising transistor is located is in a strip shape extending along the second direction, the first electrode of the output transistor comprises a second connection electrode, the second connection electrode comprises a first strip portion extending along the first direction, an end close to the output transistor in the second direction of the electrode in which the gate electrode of the second denoising transistor is located is electrically connected with a first end of the first strip portion in the first direction through a fifth via, and the second connection electrode is electrically connected with the second clock signal terminal.

21. The display substrate according to any one of claims 6 to 9, wherein the display substrate further comprises an output signal line electrically connected with the output terminal, and a portion of the output signal line that is located in the non-display region comprises a first-direction portion and a second-direction portion;
the first-direction portion of the output signal line extends along the first direction, an end of the first-direction portion that is away from the display region in the first direction is electrically connected with an electrode in which a second electrode of the output transistor is located through a first output via, so that the second electrode of the output transistor is electrically connected with the output terminal; the second-direction portion of the output signal line is connected with the first-direction portion, is located on a side of the first-direction portion that is close to the display region, and extends along the second direction as a whole to further enter the display region.

22. The display substrate according to claim 21, wherein the electrode in which the second electrode of the output transistor is located comprises a strip-shaped main body portion extending along the first direction, a plurality of strip-shaped extending portions that are connected with the strip-shaped main body portion, located on a first side of the strip-shaped main body portion in the second direction, spaced apart from each other and extend along the second direction, and a protrusion portion protruding from the strip-shaped main body portion towards a direction away from the plurality of strip-shaped extending portions in the second direction;
orthographic projections of the plurality of strip-shaped extending portions on the base substrate overlaps at least partially with both the orthographic projection of the first output semiconductor portion on the base substrate and the orthographic projection of the second output semiconductor portion on the base substrate, and the protrusion portion is located on a second side of the integral structure composed of the first output semiconductor portion and the second output semiconductor portion opposite to the first side of the integral structure composed of the first output semiconductor portion and the second output semiconductor portion in the second direction;
the first-direction portion of the output signal line is located on the second side of the integral structure composed of the first output semiconductor portion and the second output semiconductor portion in the second direction, an end of the first-direction portion that is away from the display region in the first direction is connected with the protrusion portion through the first output via, and the second-direction portion is connected with the first-direction portion, located on a side of the first-direction portion that is close to the display region, and extends along the second direction as a whole.

23. The display substrate according to claim 21 or 22, wherein the first power line is located on a side of the second electrode of the output transistor that is close to the display region in the first direction, and an orthographic projection of the first power line on the base substrate overlaps with an orthographic projection of the output signal line on the base substrate.

24. The display substrate according to claim 23, further comprising:
a second power line, configured to supply a second voltage to the shift register unit, wherein a first electrode of the second control transistor is connected with the second node, and a second electrode of the second control transistor is connected with the second power line to receive the second voltage;
a trigger signal line, wherein the display substrate comprises a plurality of cascaded shift register units, a first electrode of an input transistor in a first-stage shift register unit is connected with the input terminal, and the input terminal is configured to be connected with the trigger signal line to receive a trigger signal from the trigger signal line as an input signal;
a first clock signal line, configured to supply the first clock signal to the shift register unit;
and
a second clock signal line, configured to supply the second clock signal to the shift register unit,
the second power line, the trigger signal line, the first clock signal line, the second clock signal line, and the first power line are all arranged in a same layer as the second electrode of the second control transistor.

25. The display substrate according to any one of claims 10 to 20, wherein the second capacitor is located on a side of the integral structure composed of the first output semiconductor portion and the second output semiconductor portion that is close to the display region in the first direction;
the display substrate further comprises an output signal line; the output signal line is electrically connected with the second electrode of the second capacitor; the second electrode of the second capacitor is electrically connected with the electrode in which the second electrode of the output transistor is located through a second output via, so that the second electrode of the output transistor is electrically connected with the output terminal.

26. The display substrate according to any one of claims 3, 6 to 23, and 25, further comprising:
a second power line, configured to supply a second voltage to the shift register unit, wherein the first electrode of the second control transistor is connected with the second node, and the second electrode of the second control transistor is connected with the second power line to receive the second voltage;
a trigger signal line, wherein the display substrate comprises a plurality of cascaded shift register units, a first electrode of an input transistor in a first-stage shift register unit is connected with the input terminal, and the input terminal is configured to be connected with the trigger signal line to receive a trigger signal from the trigger signal line as an input signal;
a first clock signal line, configured to supply the first clock signal to the shift register unit;
and
a second clock signal line, configured to supply the second clock signal to the shift register unit, wherein
at least one selected from a group consisting of the second power line, the trigger signal line, the first clock signal line, and the second clock signal line overlaps with the shift register unit in a direction perpendicular to the base substrate and is arranged in a layer different from the second electrode of the second control transistor.

27. The display substrate according to claim 26, wherein the second power line extends along the second direction as a whole, at least partially overlaps with the electrode in which the gate electrode of the second control transistor is located in the direction perpendicular to the base substrate, and at least partially overlaps with the second electrode of the second control transistor in the direction perpendicular to the base substrate;
the second power line and the second electrode of the second control transistor are arranged in different layers, the second electrode of the second control transistor is located between the second power line and the electrode in which the gate electrode of the second control transistor is located, the second electrode of the second control transistor comprises a portion not overlapping with the electrode in which the gate electrode of the second control transistor is located in the direction perpendicular to the base substrate, the second power line is electrically connected with the second electrode of the second control transistor through a first power via, and the second electrode of the second control transistor is electrically connected with the active layer of the second control transistor through a first auxiliary via.

28. The display substrate according to claim 26 or 27, wherein the shift register unit further comprises a voltage stabilizing circuit, the voltage stabilizing circuit is connected with the first node and the third node, and is configured to stabilize the level of the third node; the control terminal of the output circuit is connected with the third node; the output circuit is configured to output the output signal to the output terminal under control of the level of the third node; the voltage stabilizing circuit comprises a voltage stabilizing transistor, an active layer of the voltage stabilizing transistor and the second capacitor are both located on the first side of the integral structure composed of the first output semiconductor portion and the second output semiconductor portion in the first direction; and
the second power line at least partially overlaps with an electrode in which the gate electrode of the voltage stabilizing transistor is located in the direction perpendicular to the base substrate, and the second power line is electrically connected with the electrode in which the gate electrode of the voltage stabilizing transistor is located through a second power via.

29. The display substrate according to claim 27, wherein the second power line further at least partially overlaps with the input transistor and the second capacitor in the direction perpendicular to the base substrate.

30. The display substrate according to any one of claims 26 to 29, wherein the trigger signal line extends along the second direction and at least partially overlaps with the first electrode of the input transistor of the first-stage shift register unit in the direction perpendicular to the base substrate, and the trigger signal line is electrically connected with the first electrode of the input transistor of the first-stage shift register unit through a trigger via.

31. The display substrate according to any one of claims 26 to 30, wherein the first clock signal line extends along the second direction as a whole and at least partially overlaps with an electrode in which the gate electrode of the input transistor and a gate electrode of the second control transistor are located in the direction perpendicular to the base substrate, and the first clock signal line is electrically connected with the electrode in which the gate electrode of the input transistor and the gate electrode of the second control transistor of the first-stage shift register unit are located through a first clock via.

32. The display substrate according to any one of claims 26 to 31, wherein the second clock signal line extends along the second direction and at least partially overlaps with an electrode in which a first electrode of the output transistor is located in the direction perpendicular to the base substrate, and the second clock signal line is electrically connected with the electrode in which the first electrode of the output transistor is located through a second clock via.

33. The display substrate according to claim 32, wherein in a case where an electrode in which a gate electrode of the second denoising transistor is located is in a strip shape extending along the second direction, the first electrode of the output transistor comprises a second connection electrode, the second connection electrode comprises a first strip portion extending along the first direction, an end close to the output transistor in the second direction of the electrode in which the gate electrode of the second denoising transistor is located is electrically connected with a first end of the first strip portion in the first direction through a fifth via, and the second connection electrode is electrically connected with the second clock signal terminal,
the second clock signal line at least partially overlaps with the first strip portion in the direction perpendicular to the base substrate, and the second clock signal line is electrically connected with the first strip portion through the second clock via, so that the gate electrode of the second denoising transistor and the first electrode of the output transistor are both connected with the second clock signal terminal.

34. The display substrate according to any one of claims 26 to 33, wherein the second power line, the trigger signal line, the first clock signal line, and the second clock signal line all overlap with the shift register unit in the direction perpendicular to the base substrate;
the second power line, the trigger signal line, the first clock signal line, and the second clock signal line are arranged in a same layer, and are all arranged in a layer different from the first electrode of the output transistor.

35. A display device, comprising the display substrate according to any one of claims 1 to 34.

36. The display device according to claim 35, wherein the display device further comprises a plurality of pixel units located in the display region and arranged in an array, at least a part of the plurality of pixel units comprise a light emitting device, the output signal output by the output circuit of the shift register unit serves as a gate scan signal to drive the light emitting devices of the plurality of pixel units to emit light.
